(19) Europäisches Patentamt
European Patent Office
Office européen des brevets

(11) EP 2 660 068 B1

(12) # EUROPEAN PATENT SPECIFICATION

(45) Date of publication and mention of the grant of the patent:
**29.07.2015 Bulletin 2015/31**

(21) Application number: **11852391.9**

(22) Date of filing: **30.11.2011**

(51) Int Cl.:
***B41C 1/10*** (2006.01) ***G03F 7/30*** (2006.01)
***G03F 7/033*** (2006.01) ***G03F 7/038*** (2006.01)

(86) International application number:
**PCT/JP2011/077709**

(87) International publication number:
**WO 2012/090639 (05.07.2012 Gazette 2012/27)**

(54) **PLANOGRAPHIC PRINTING PLATE PRECURSOR AND PLANOGRAPHIC PRINTING METHOD**

FLACHDRUCKPLATTENVORLÄUFER UND FLACHDRUCKVERFAHREN

PRÉCURSEUR DE PLAQUE D'IMPRESSION PLANOGRAPHIQUE ET PROCÉDÉ D'IMPRESSION PLANOGRAPHIQUE

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **28.12.2010 JP 2010294337**

(43) Date of publication of application:
**06.11.2013 Bulletin 2013/45**

(73) Proprietor: **FUJIFILM Corporation**
**Tokyo 106-0031 (JP)**

(72) Inventors:
- **KANEHISA Mayuko**
  **Haibara-gun**
  **Shizuoka (JP)**
- **OOHASHI Hidekazu**
  **Haibara-gun**
  **Shizuoka (JP)**
- **KOYAMA Ichiro**
  **Haibara-gun**
  **Shizuoka (JP)**

(74) Representative: **Hoffmann Eitle**
**Patent- und Rechtsanwälte PartmbB**
**Arabellastraße 30**
**81925 München (DE)**

(56) References cited:
**JP-A- 2002 365 789** **JP-A- 2004 317 543**
**JP-A- 2007 249 036** **JP-A- 2010 234 587**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

EP 2 660 068 B1

## Description

### TECHNICAL FIELD

The present invention relates to a lithographic printing plate precursor and a lithographic printing method. More particularly, it relates to a lithographic printing plate precursor suitably used for a lithographic printing plate precursor which is capable of undergoing a so-called direct plate making in which the plate making is directly conducted based on digital signals, for example, from a computer using various kinds of lasers and a lithographic printing method.

### BACKGROUND ART

In general, a lithographic printing plate is composed of an oleophilic image area accepting ink and a hydrophilic non-image area accepting dampening water in the process of printing. Lithographic printing is a printing method utilizing the nature of water and oily ink to repel with each other and comprising rendering the oleophilic image area of the lithographic printing plate to an ink-receptive area and the hydrophilic non-image area thereof to a dampening water-receptive area (ink-unreceptive area), thereby making a difference in adherence of the ink on the surface of the lithographic printing plate, depositing the ink only to the image area, and then transferring the ink to a printing material, for example, paper.

In order to produce the lithographic printing plate, a lithographic printing plate precursor (PS plate) comprising a hydrophilic support having provided thereon an oleophilic photosensitive resin layer (image-recording layer) is heretofore used. Specifically, the PS plate is exposed through a mask, for example, a lith film, and then subjected to development processing, for example, with an alkaline developer to remove the unnecessary image-recording layer corresponding to the non-image area by dissolving while leaving the image-recording layer corresponding to the image area, thereby obtaining the lithographic printing plate.

Due to the recent progress in the technical field, nowadays the lithographic printing plate can be obtained by a CTP (computer-to-plate) technology. Specifically, a lithographic printing plate precursor is directly subjected to scanning exposure using laser or laser diode without using a lith film and developed to obtain a lithographic printing plate.

With the progress described above, the issue on the lithographic printing plate precursor has transferred to improvements, for example, in image-forming property corresponding to the CTP technology, printing property or physical property. Also, with the increasing concern about global environment, as another issue on the lithographic printing plate precursor, an environmental problem on waste liquid discharged accompanying the wet treatment, for example, development processing comes to the front.

In response to the environmental problem, simplification of development or plate making or non-processing has been pursued. As one method of simple plate making, a method referred to as an "on-press development" is practiced. Specifically, according to the method after exposure of a lithographic printing plate precursor, the lithographic printing plate precursor is mounted as it is on a printing machine without conducting conventional development and removal of the unnecessary area of image-recording layer is performed at an early stage of printing process.

Also, as a method of simple development, a method referred to as a "gum development" is practiced in which removal of the unnecessary area of image-recording layer is performed using not a conventional highly alkaline developer but a finisher or gum solution of near-neutral pH.

In the simplification of plate making operation as described above, a system using a lithographic printing plate precursor capable of being handled in a bright room or under a yellow lamp and a light source is preferred from the standpoint of workability. Thus, as the light source, a semiconductor laser emitting an infrared ray having a wavelength of 760 to 1,200 or a solid laser, for example, YAG laser, is used. An UV laser is also used.

As the lithographic printing plate precursor capable of undergoing on-press development, for instance, a lithographic printing plate precursor having provided on a hydrophilic support, an image-recording layer (heat-sensitive layer) containing microcapsules having a polymerizable compound encapsulated therein is described in Patent Document 1 or 2. A lithographic printing plate precursor having provided on a support, an image-recording layer (photosensitive layer) containing an infrared absorbing agent, a radical polymerization initiator and a polymerizable compound is described in Patent Document 3. A lithographic printing plate precursor capable of undergoing on-press development having provided on a support, an image-recording layer containing a polymerizable compound and a graft polymer having a polyethylene oxide chain in its side chain or a block polymer having a polyethylene oxide block is described in Patent Document 4. A lithographic printing plate precursor having provided on a support, an image-forming layer containing a polymer compound (hereinafter, also referred to as a "star polymer") in which the main chain is branched to three or more branches is also proposed as a lithographic printing plate precursor capable of undergoing on-press development in Patent Document 5. However, these techniques are still insufficient for obtaining both good development property and high printing durability.

Further, a crosslinkable functional group is introduced into a star polymer to increase film strength of paint or

the like is described in Patent Document 6 or 7. However, these techniques provide only insufficient result particularly in view of development property when they are applied to a lithographic printing plate precursor.

PRIOR ART DOCUMENT

PATENT DOCUMENT

Patent Document 1: JP-A-2001-277740
Patent Document 2: JP-A-2001-277742
Patent Document 3: JP-A-2002-287334
Patent Document 4: U.S. Patent Publication No. 2003/0064318
Patent Document 5: JP-A-2007-249036
Patent Document 6: Japanese Patent No. 3,084,227
Patent Document 7: JP-A-6-87908

DISCLOSURE OF THE INVENTION

PROBLEMS THAT THE INVENTION IS TO SOLVE

An object of the present invention is to provide a lithographic printing plate precursor which has good developing property while maintaining printing durability of a lithographic printing plate after development and a lithographic printing method.

MEANS FOR SOLVING THE PROBLEMS

As a result of the intensive investigations, the inventor has solved the problem by incorporating into an image-recording layer a polymerizable composition containing a fine particle of polymer having a polyethyleneoxy group in its side chain and a polymer compound having a star-like shape in which a main chain is branched to three or more branches and the branched main chains have at least any of a polyethyleneoxy group and a polypropyleneoxy group in their side chains.

Specifically, the present invention includes the following items.

(1) A lithographic printing plate precursor comprising on a support having a hydrophilic surface, an image-recording layer containing a polymerizable compound, a polymerization initiator, a fine particle of polymer having a polyethyleneoxy group in its side chain and a polymer compound, wherein the polymer compound has a star-like shape in which a main chain is branched to three or more branches and the branched main chains have at least any of a polyethyleneoxy group and a polypropyleneoxy group in their side chains.

(2) The lithographic printing plate precursor as described in (1) above, wherein the polymer compound having a star-like shape in which a main chain is branched to three or more branches has an ethylenically unsaturated group in a side chain of the branched main chain.

(3) The lithographic printing plate precursor as described in (1) or (2) above, wherein the polymer compound having a star-like shape in which a main chain is branched to three or more branches has a polyethyleneoxy group in a side chain of the branched main chain.

(4) The lithographic printing plate precursor as described in any one of (1) to (3) above, wherein the polymer compound having a star-like shape in which a main chain is branched to three or more branches is obtained by radical polymerization of a monomer having at least any of a polyethyleneoxy group and a polypropyleneoxy group in the presence of a compound having three or more thiol groups.

(5) The lithographic printing plate precursor as described in any one of (1) to (4) above, wherein the image-recording layer contains an infrared absorbing agent.

(6) The lithographic printing plate precursor as described in any one of (1) to (5) above, wherein a protective layer is provided on the image-recording layer.

(7) The lithographic printing plate precursor as described in any one of (1) to (6) above, wherein the image-recording layer is capable of being removed with at least any of printing ink and dampening water.

(8) A lithographic printing method comprising after either mounting the lithographic printing plate precursor as described in (7) above on a printing machine and exposing imagewise the lithographic printing plate precursor with

laser or exposing imagewise the lithographic printing plate precursor as described in (7) above with laser and mounting the exposed lithographic printing plate precursor on a printing machine, supplying at least any of printing ink and dampening water on the exposed lithographic printing plate precursor to remove an unexposed area of the image-recording layer and performing printing.

According to the invention, the problem described above is solved by incorporating into an image-recording layer a fine particle of polymer having a polyethyleneoxy group in its side chain and a polymer compound having a star-like shape in which a main chain is branched to three or more branches and the branched main chains have at least any of a polyethyleneoxy group and a polypropyleneoxy group in their side chains.

The functional mechanism of the invention is not quite clear but it is estimated that dispersibility of a fine particle of polymer having a polyethyleneoxy group in its side chain and a polymer compound having at least any of a polyethyleneoxy group and a polypropyleneoxy group in its side chain in the image-recording layer is improved by using a star polymer as the polymer compound in comparison with a conventional strait-chain polymer and as a result the developing property is more improved while maintaining printing durability of a lithographic printing plate after development.

ADVANTAGE OF THE INVENTION

According to the present invention, a lithographic printing plate precursor which has good developing property while maintaining printing durability of a lithographic printing plate after development and a lithographic printing method can be provided.

BRIEF DESCRIPTION OF THE DRAWING

Fig. 1 is a view schematically showing a main chain structure of a star polymer.
Fig. 2 is a view explaining a structure of an automatic development processor.

MODE FOR CARRYING OUT THE INVENTION

The lithographic printing plate precursor according to the invention comprises on a support having a hydrophilic surface, an image-recording layer containing a polymerizable compound, a polymerization initiator, a fine particle of polymer having a polyethyleneoxy group in its side chain and a polymer compound, wherein the polymer compound has a star-like shape in which a main chain is branched to three or more branches and the branched main chains have at least any of a polyethyleneoxy group and a polypropyleneoxy group in their side chains.

The components and constituting elements which are used in the lithographic printing plate precursor according to the invention will be described in detail below.

[Star polymer]

The polymer compound for use in the invention is a star polymer in which a main chain is branched to three or more branches and a polymer compound which has a main chain structure as schematically shown in Fig. 1 and is represented by formula (1) shown below.

Formula (1) $A\{Polymer)_n$

In formula (1), A represents a branch unit (constituting unit including branch points) of the star polymer, Polymer represents a polymer chain constituting a main chain and has at least any of a polyethyleneoxy group and a polypropyleneoxy group in its side chain, and n represents 3 or more.

[Polymer moiety]

The star polymer for use in the invention is a polymer compound which has the main chain structure as described above and the polymer chain has at least any of a polyethyleneoxy group and a polypropyleneoxy group in its side chain.

The side chain may contain either a polyethyleneoxy group alone or a polypropyleneoxy group alone, or both of them.

The polyethyleneoxy group or polypropyleneoxy group is a group represented by formula (2) shown below.

Formula (2)

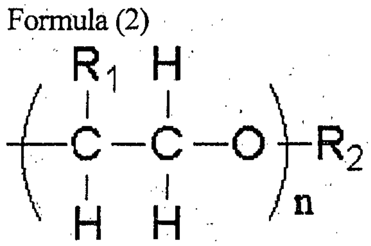

In formula (2), $R_1$ represents a hydrogen atom or a methyl group, $R_2$ represents a hydrogen atom or an alkyl group having from 1 to 12 carbon atoms, and n represents from 2 to 120. $R_1$ is preferably a hydrogen atom. $R_2$ is preferably a hydrogen atom or a methyl group. n is preferably from 2 to 90, more preferably from 2 to 50, still more preferably from 2 to 12, and particularly preferably from 2 to 8.

In order to introduce the polyethyleneoxy group or polypropyleneoxy group into the side chain of Polymer in formula (1), a monomer represented by formula (3) shown below may be copolymerized.

Formula (3)

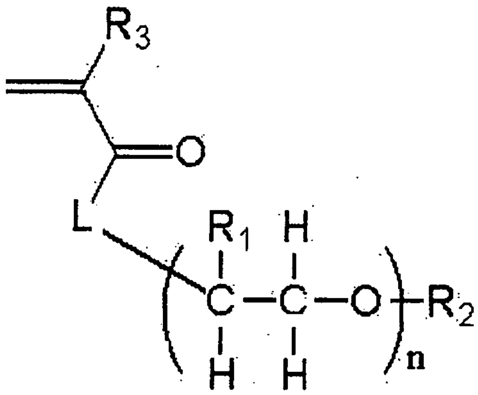

In formula (3), $R_3$ represents a methyl group or a hydrogen atom, L represents an oxygen atom or NH. L is preferably an oxygen atom. $R_1$, $R_2$ and n have the same meanings as $R_1$, $R_2$ and n defined in formula (2) respectively, and preferred examples thereof are also the same.

Specific examples of the monomer represented by formula (3) are set forth below.

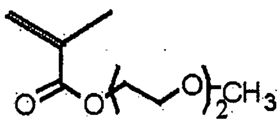 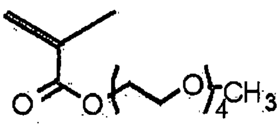 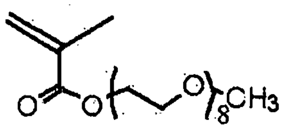 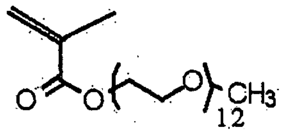

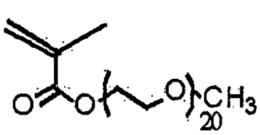 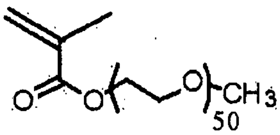 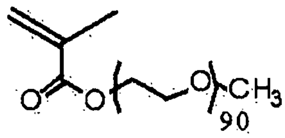

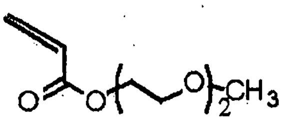 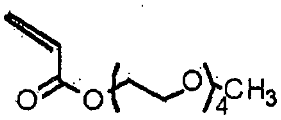 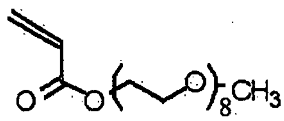 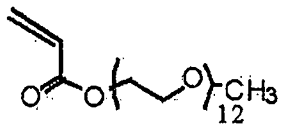

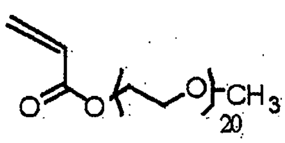
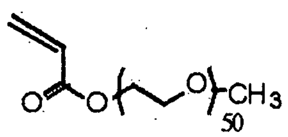
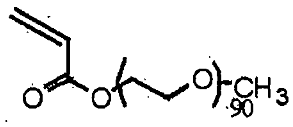

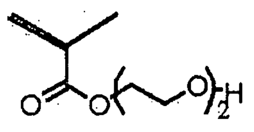
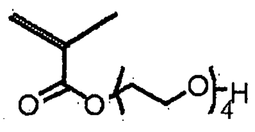
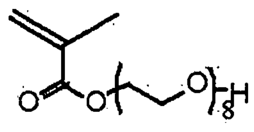
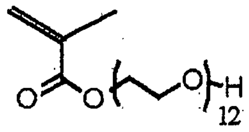

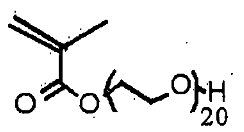
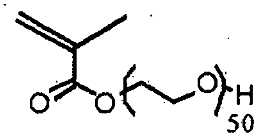
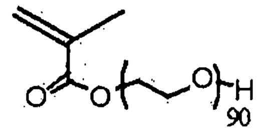

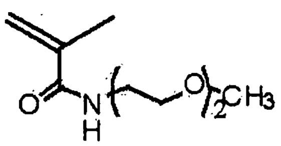
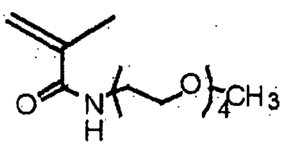
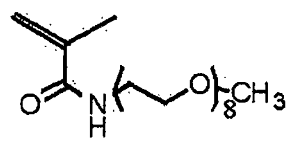
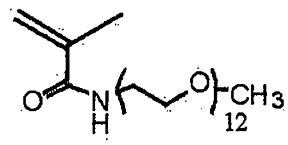

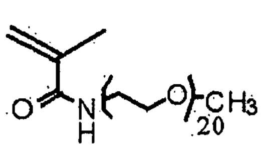
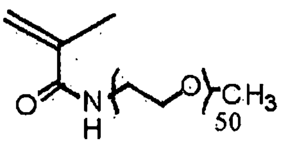
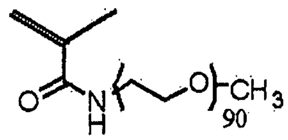

The content of repeating unit derived from the monomer represented by formula (3) is preferably from 20 to 80% by weight, more preferably from 30 to 70% by weight, particularly preferably from 35 to 65% by weight, in the polymer compound represented by formula (1).

Also, in order to increase film strength of the image area Polymer in formula (1) desirably contains a repeating unit having an ethylenically unsaturated group. The ethylenically unsaturated group forms crosslinkage between the polymer molecules at the time of photopolymerization to accelerate photo-curing.

As the ethylenically unsaturated group, for example, a (meth)acryl group, a vinyl group or an allyl group is preferred. The ethylenically unsaturated group can be introduced into the polymer by a polymer reaction or copolymerization. For instance, a reaction between an acrylic polymer having a carboxyl group in its side chain and glycidyl methacrylate, a reaction between a polymer having an epoxy group and a carboxylic acid having an ethylenically unsaturated group, for example, methacrylic acid, or a reaction between a polymer having a hydroxy group and a methacrylate having an isocyanate group can be utilized.

From the standpoint of preservation stability of the polymer compound and film strength, a (meth)acryl group is preferred.

Specific examples of the repeating unit having an ethylenically unsaturated group for use in the invention are set forth below, but the invention should not be construed as being limited thereto.

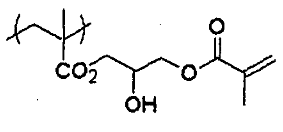
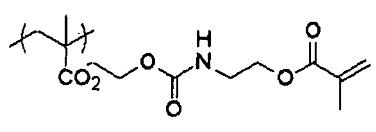
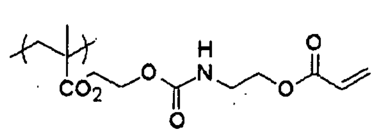

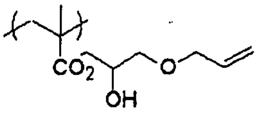

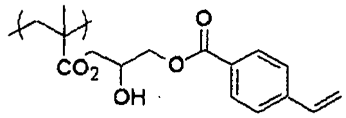

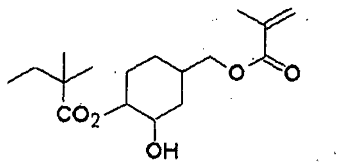

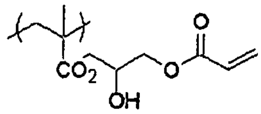

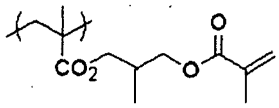

The content of the ethylenically unsaturated group in the polymer compound according to the invention is preferably from 0.1 to 10.0 mmol, more preferably from 0.25 to 7.0 mmol, most preferably from 0.5 to 5.5 mmol, per g of the polymer compound.

The star polymer for use in the invention may contain other repeating unit. Specific examples of monomer corresponding to such a repeating unit are set forth below, but the invention should not be construed as being limited thereto.

(m1) Acrylates and methacrylates each having an aliphatic hydroxy group, for example, 2-hydroxyethyl acrylate or 2-hydroxyethyl methacrylate

(m2) Alkyl acrylates, for example, methyl acrylate, ethyl acrylate, propyl acrylate, butyl acrylate, amyl acrylate, hexyl acrylate, octyl acrylate, benzyl acrylate, 2-chloroethyl acrylate or glycidyl acrylate

(m3) Alkyl methacrylates, for example, methyl methacrylate, ethyl methacrylate, propyl methacrylate, butyl methacrylate, amyl methacrylate, hexyl methacrylate, cyclohexyl methacrylate, benzyl methacrylate, 2-chloroethyl methacrylate or glycidyl methacrylate

(m4) Acrylamides and methacrylamides, for example, acrylamide, methacrylamide, N-methylolacrylamide, N-ethylacrylamide, N-hexylmethacrylamide, N-cyclohexylacrylamide, N-hydroxyethylacrylamide, N-phenylacrylamide, N-nitrophenylacrylamide or N-ethyl-N-phenylacrylamide

(m5) Vinyl ethers, for example, ethyl vinyl ether, 2-chloroethyl vinyl ether, hydroxyethyl vinyl ether, propyl vinyl ether, butyl vinyl ether, octyl vinyl ether or phenyl vinyl ether

(m6) Vinyl esters, for example, vinyl acetate, vinyl chloroacetate, vinyl butyrate or vinyl benzoate (m7) Styrenes, for example, styrene, $\alpha$-methylstyrene, methylstyrene or chloromethylstyrene

(m8) Vinyl ketones, for example, methyl vinyl ketone, ethyl vinyl ketone, propyl vinyl ketone or phenyl vinyl ketone

(m9) Olefins, for example, ethylene, propylene, isobutylene, butadiene or isoprene

(m10) N-vinylpyrrolidone, acrylonitrile or methacrylonitrile

(m11) Unsaturated imides, for example, maleimide, N-acetylmethacrylamide, N-propionylmethacrylamide or N-(p-chlorobenzoyl)methacrylamide.

Specific examples of the polymer chain represented by Polymer in formula (1) are set forth below. The copolymerization ratio is indicated as a molar ratio.

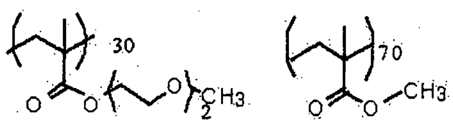
B-1

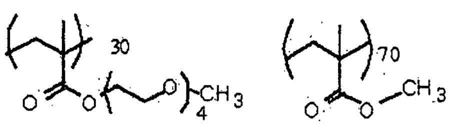
B-2

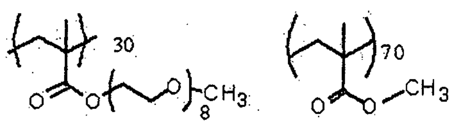
B-3

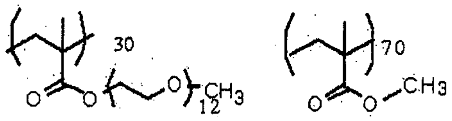

B-4

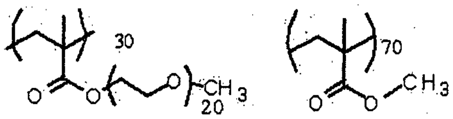

B-5

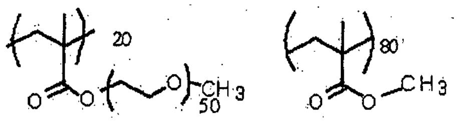

B-6

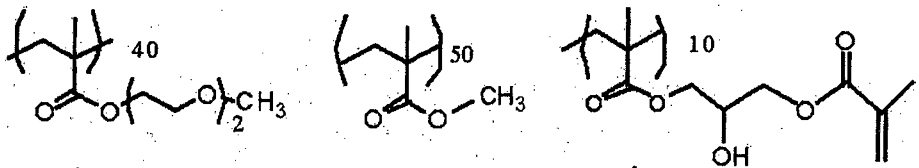

B-7

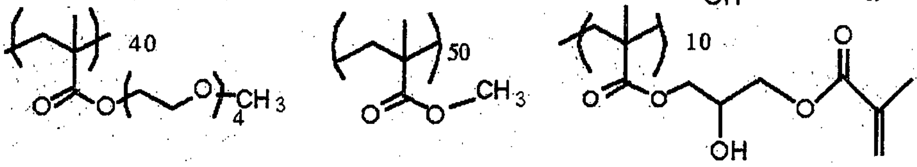

B-8

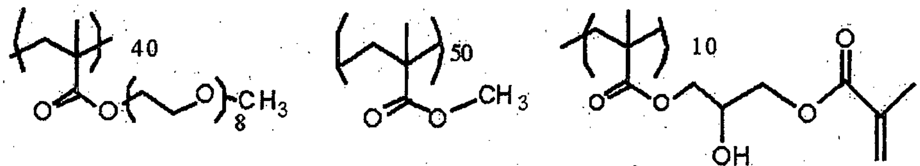

B-9

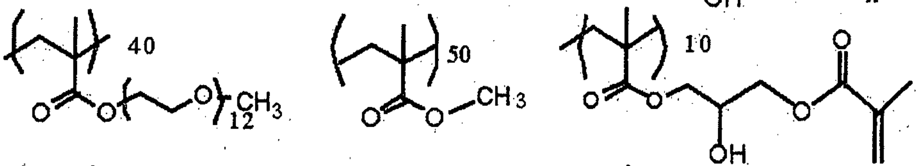

B-10

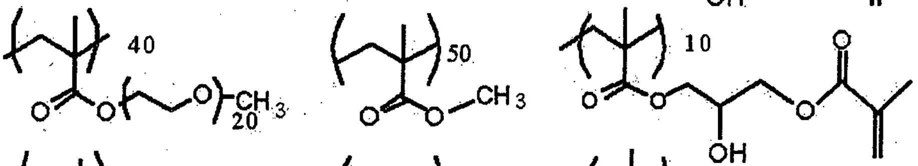

B-11

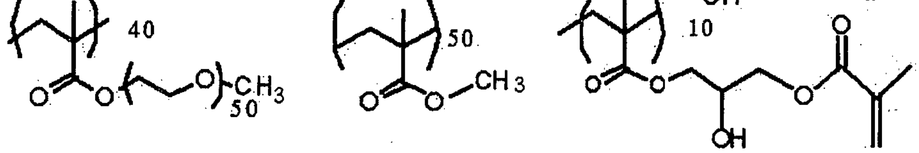

B-12

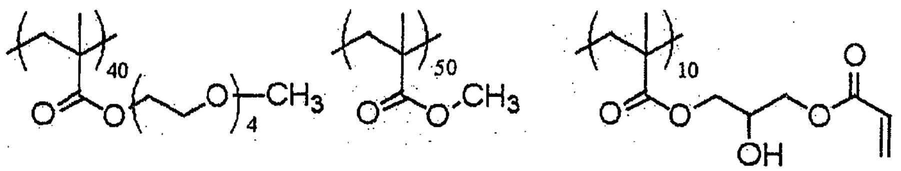

B-13

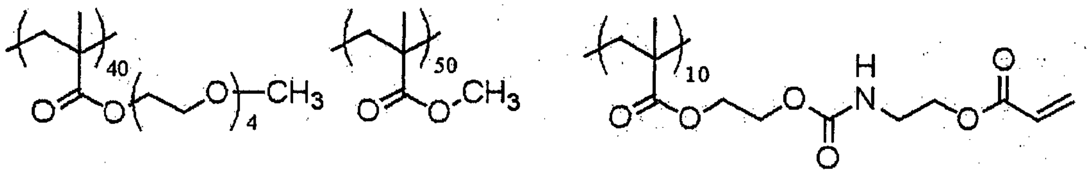
B-14

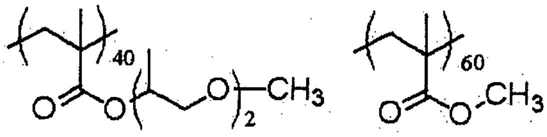
B-15

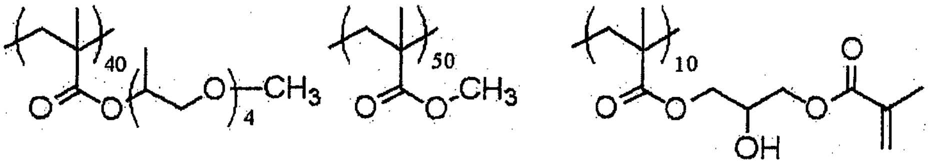
B-16

[Branch unit A]

The branch unit represented by A in formula (1) is not particularly restricted and is preferably a branch unit having a hub portion, which is a residue of a three or higher functional thiol. In the idealized structure, a main chain of an addition polymer extends from each thio part of the hub portion and thus, three or more main chains extend from the thio parts. Specifically, the branch unit A has preferably a structure represented by formula (4) shown below.

Formula (4)

$$A_1\left(-S-\right)_n$$

In formula (4), $A_1$ represents an n-valent organic group, and n represents an integer of 3 or more. Specific examples of $A_1$ include structures shown below and organic groups composed of combination of two or more of these structures. n is preferably an integer from 3 to 6, and particularly preferably an integer from 4 to 6.

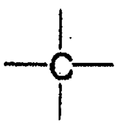 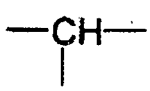

$-CH_2-$ -O-

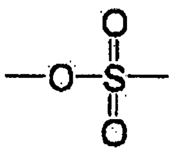

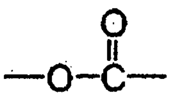 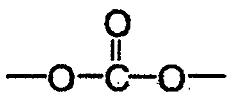

-S-

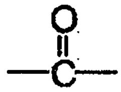

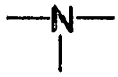

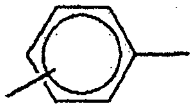

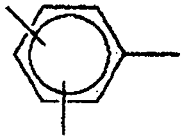

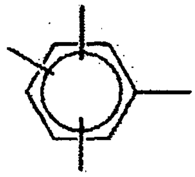

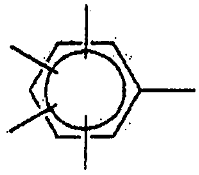

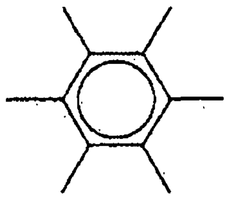

**Polyvalent naphthalene, Polyvalent anthracene**

The three or higher functional thiol residue is derived from an aromatic or aliphatic thiol. Examples of the aromatic thiol include benzene-1,3,5-trithiol, 3,4,8,9-tetramercaptotetrathiafulvalene and 7-methyltrithiouric acid.

The thiol residue of the aliphatic thiol is preferably a residue of an ester formed from a three or higher functional alcohol and a mercaptoalkanoic acid having from 2 to 6 carbon atoms.

Examples of the appropriate alcohol include glycerine, sorbitol, an alcohol represented by formula (5) and an alcohol having a group represented by formula (6). In particular, the alcohol represented by formula (5) and alcohol having a group represented by formula (6) are preferred.

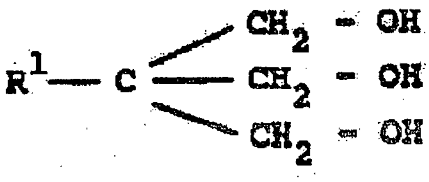

(5)

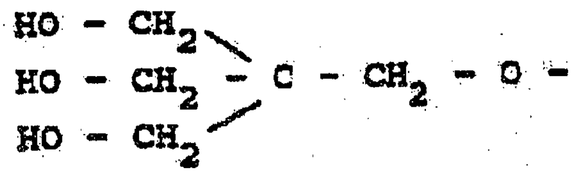

(6)

In formulae (5) and (6), $R^1$ represents a hydrogen atom, an alkyl group having from 1 to 4 carbon atoms or a hydroxy-substituted alkyl group having from 1 to 4 carbon atoms. In particular, $R^1$ is preferably a methyl group, an ethyl group, a hydroxymethyl group or a hydroxyethyl group.

Examples of the mercaptoalkanoic acid having from 2 to 6 carbon atoms include 2-mercaptoacetic acid, 2-mercaptopropionic acid, 3-mercaptopropionic acid, 4-mercaptobutyric acid, 5-mercaptovaleric acid and 6-mercaptocaproic acid. Among them, 2-mercaptoacetic acid and 3-mercaptopropionic acid are preferred.

Specific examples of the ester formed from a three or higher functional alcohol and a mercaptoalkanoic acid having from 2 to 6 carbon atoms include a compound having three mercapto groups, for example, 1,2,6-hexanetrioltrithioglycolate, 1,3,5-trithiocyanuric acid, 1,3,5-tris(3-mercaptobutyryloxyethyl)-1,3,5-triazine-2,4,6(1H,3H,5H)-trione, trimethylolpropane tris(3-mercaptopropionate), trimethylolpropane tristhioglycolate, trimethylolpropane tristhiopropionate, trihydroxyethyltriisocyanuric acid tristhiopropionate or tris-[(ethyl-3-mercaptopropionyloxy)ethyl] isocyanurate, and a compound having four mercapto groups, for example, pentaerythritol tetrakis(3-mercaptopropionate), pentaerythritol tetrakis(3-mercaptobutyrate), pentaerythritol tetrakisthioglycolate or dipentaerythritol hexakis-3-mercaptopropionate, but the invention should not be construed as being limited thereto.

Commercially available products of the multifunctional thiol compound include trimethylolpropane tristhiopropionate (TMTG) (trademark) and pentaerythritol tetrakisthiopropionate (PETG) (trademark) (each produced by Yodo

Kagaku Co., Ltd.), pentaerythritol tetrakis(3-mercaptobutyrate) (KarenzMT PE1) (trademark) and 1,3,5-tris(3-mercaptobutyryloxyethyl)-1,3,5-triazine-2,4,6(1H,3H,5H)-trione (KarenzMT NR1) (trademark) (each produced by Showa Denko K.K.), and trimethylolpropane tris-3-mercaptopropionate (TMMP) (trademark), pentaerythritol tetrakis-3-mercaptopropionate (PEMP) (trademark), dipentaerythritol hexakis-3-mercaptopropionate (DPMP) (trademark) and tris-[(ethyl-3-mercaptopropionyloxy)ethyl] isocyanurate (TEMPIC) (trademark) (each produced by Sakai Chemical Industry Co., Ltd.), but the multifunctional thiol compound according to the invention should not be construed as being limited thereto.

The branch unit represented by formula (4) includes structures shown below.

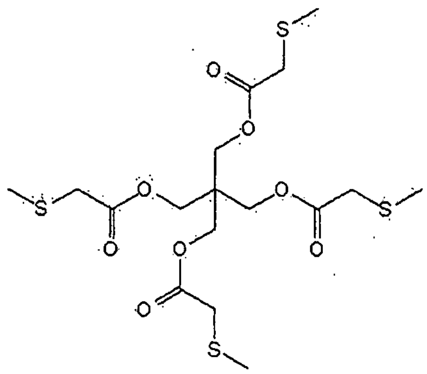

A-1

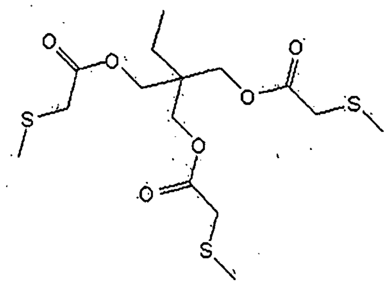

A-2

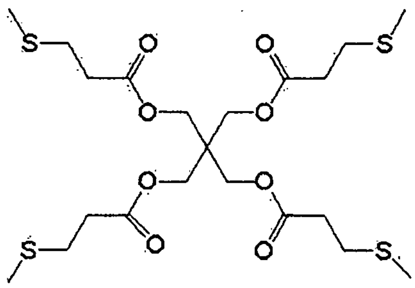

A-3

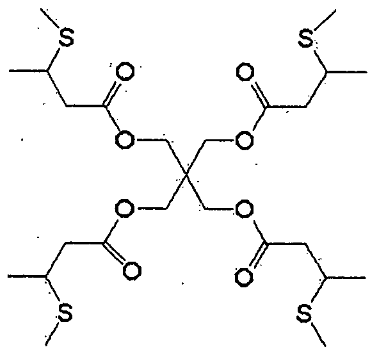

A-4

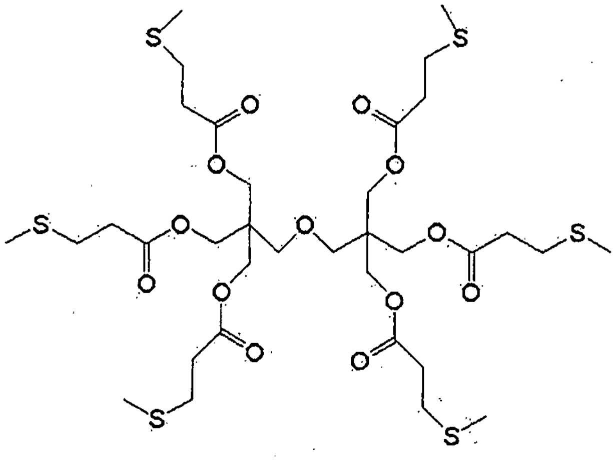

A-5

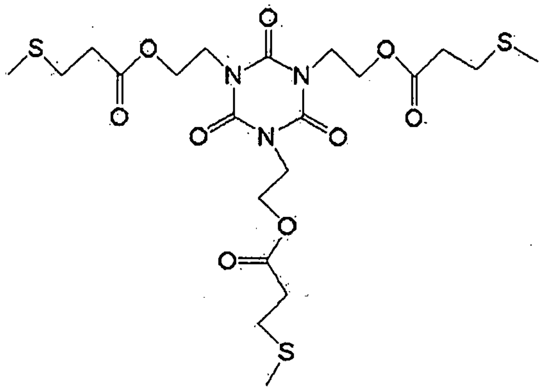

A-6

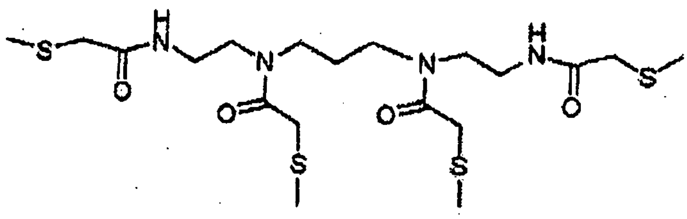

A-7

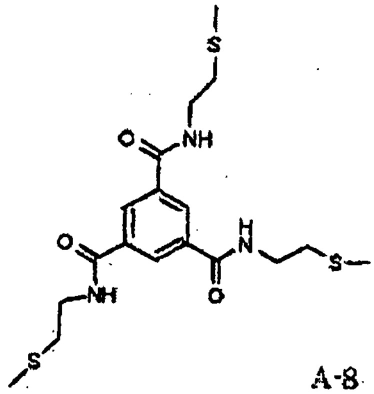

A-8

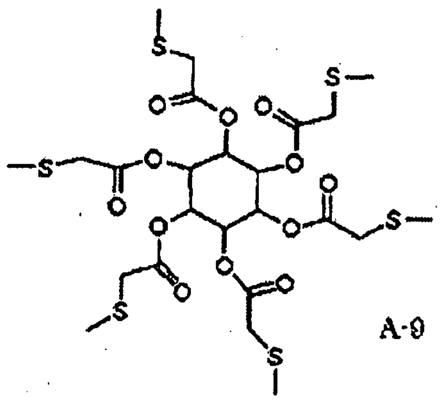

A-9

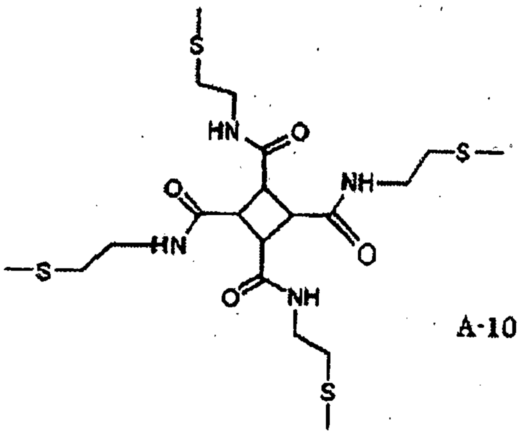

A-10

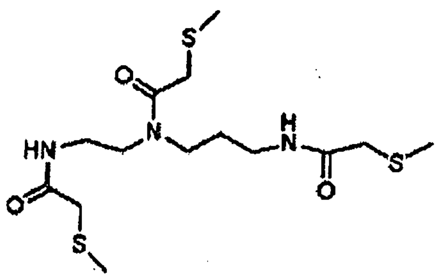

A-11

The weight average molecular weight (Mw) of the star polymer for use in the invention is preferably from 5,000

to 500,000, and more preferably from 10,000 to 250,000.

Specific examples of the star polymer for use in the invention are set forth below, but the invention should not be construed as being limited thereto.

TABLE 1: Specific Examples of Star Polymer according to Invention

| Star Polymer | Branch Unit | Polymer Chain | Mw |
|---|---|---|---|
| P-1 | A-1 | B-1 | $3.5 \times 10^4$ |
| P-2 | A-2 | B-1 | $2.7 \times 10^4$ |
| P-3 | A-3 | B-1 | $3.6 \times 10^4$ |
| P-4 | A-4 | B-1 | $3.6 \times 10^4$ |
| P-5 | A-5 | B-1 | $5.2 \times 10^4$ |
| P-6 | A-6 | B-1 | $2.7 \times 10^4$ |
| P-7 | A-7 | B-1 | $3.1 \times 10^4$ |
| P-8 | A-8 | B-1 | $3.1 \times 10^4$ |
| P-9 | A-9 | B-1 | $5.5 \times 10^4$ |
| P-10 | A-10 | B-1 | $3.5 \times 10^4$ |
| P-11 | A-1 | B-7 | $4.6 \times 10^4$ |
| P-12 | A-2 | B-7 | $3;8 \times 10^4$ |
| P-13 | A-3 | B-7 | $4.6 \times 10^4$ |
| P-14 | A-4 | B-7 | $4.5 \times 10^4$ |
| P-15 | A-5 | B-7 | $6.3 \times 10^4$ |
| P-16 | A-6 | B-7 | $3.8 \times 10^4$ |
| P-17 | A-7 | B-7 | $4.0 \times 10^4$ |
| P-18 | A-8 | B-7 | $4.1 \times 10^4$ |
| P-19 | A-9 | B-7 | $6.6 \times 10^4$ |
| P-20 | A-10 | B-7 | $4.6 \times 10^4$ |
| P-21 | A-1 | B-2 | $3.5 \times 10^4$ |
| P-22 | A-1 | B-3 | $3.6 \times 10^4$ |
| P-23 | A-1 | B-4 | $3.7 \times 10^4$ |
| P-24 | A-1 | B-5 | $3.8 \times 10^4$ |
| P-25 | A-1 | B-6 | $4.3 \times 10^4$ |
| P-26 | A-1 | B-8 | $4.6 \times 10^4$ |
| P-27 | A-1 | B-9 | $4.7 \times 10^4$ |
| P-28 | A-1 | B-10 | $4.8 \times 10^4$ |
| P-29 | A-1 | B-11 | $4.9 \times 10^4$ |
| P-30 | A-1 | B-13 | $4.6 \times 10^4$ |
| P-31 | A-1 | B-14 | $4.7 \times 10^4$ |
| P-32 | A-1 | B-15 | $3.6 \times 10^4$ |
| P-33 | A-1 | B-16 | $4.6 \times 10^4$ |

The star polymers according to the invention may be used in the image-recording layer only one kind or two or more kinds thereof in combination. The content of the star polymer according to the invention in the image-recording

layer is preferably from 0.5 to 90% by weight, more preferably from 1 to 80% by weight, still more preferably from 1.5 to 70% by weight, based on the total solid content of the image-recording layer.

The star polymer according to the invention can be synthesized by a known method, for example, radical polymerization of the monomer constituting the polymer chain described above in the presence of the multifunctional thiol compound described above.

[Fine particle of polymer having polyethyleneoxy group in its side chain]

A fme particle of polymer having a polyethyleneoxy group in its side chain is used in the image-recording layer according to the invention in order to increase on-press development property. By the interaction between the fine particle of polymer having a polyethyleneoxy group and the star polymer described above, the development property is increased while maintaining printing durability of a lithographic printing plate after development.

A number of the ethyleneoxy repeating unit in the polyethyleneoxy group is preferably from 2 to 120, more preferably from 20 to 100, and particularly preferably from 20 to 70. In the range described above, good printing durability and good ink receptivity are obtained.

A polymer constituting the main chain of the polymer forming fine particle includes, for example, a vinyl resin, a polyurethane resin, a polyurea resin, a polyimide resin, a polyamide resin, an epoxy resin, a polystyrene resin, a novolac type phenolic resin, a polyester resin, a synthesis rubber and a natural rubber. In particular, a vinyl resin is preferred.

The polyethyleneoxy group is preferably incorporated into a polymer forming fme particle as its side chain, more preferably incorporated into a vinyl resin as its side chain, in the structure represented by formula (7) shown below.

Formula (7)

$$-\left(CH_2-CH_2-O\right)_n-R$$

In formula (7), R represents a hydrogen atom or an alkyl group having from 1 to 12 carbon atoms, and n represents from 2 to 120. R is preferably a hydrogen atom or a methyl group. n is preferably from 20 to 100, and particularly preferably from 20 to 70.

The fine particle of polymer having such a side chain is obtained by copolymerization of a monomer represented by formula (8) shown below.

Formula (8)

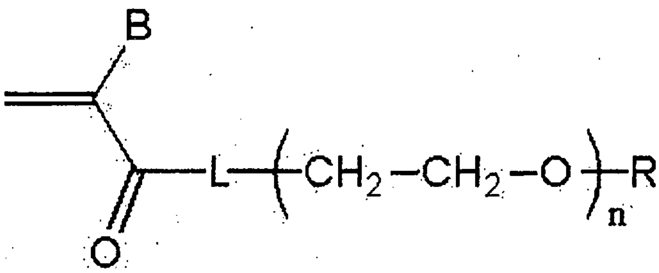

In formula (8), B represents a methyl group or a hydrogen atom. L represents an oxygen atom or NH, and is preferably an oxygen atom. R and n have the same meaning as those defined in formula (7) respectively, and preferred examples thereof are also the same.

Specific examples of the monomer represented by formula (8) are set forth below.

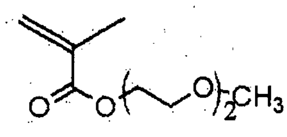 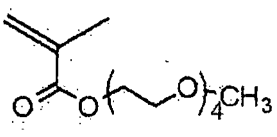 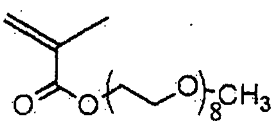 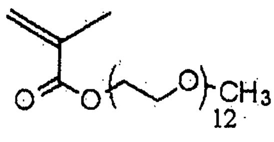

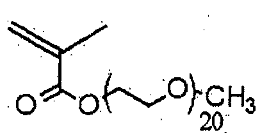 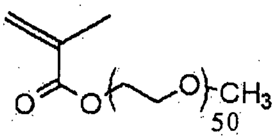 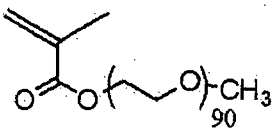

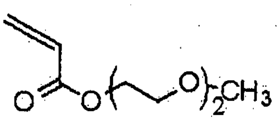 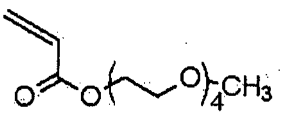 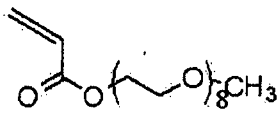 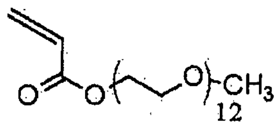

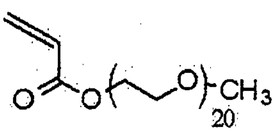 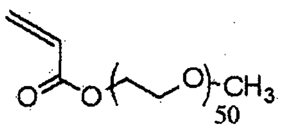 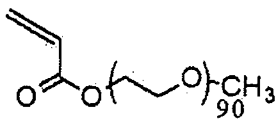

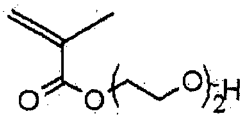 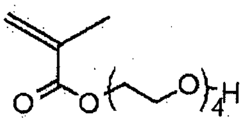 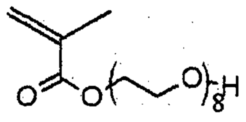 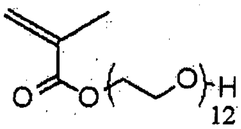

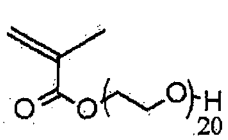 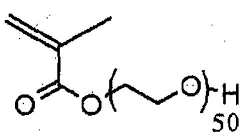 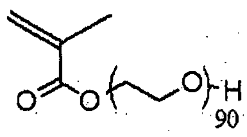

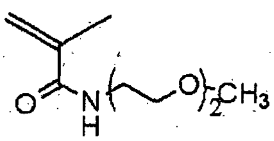 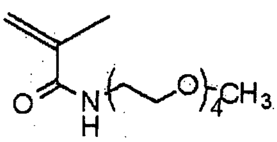 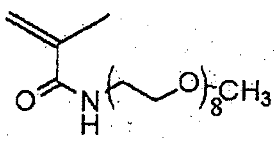 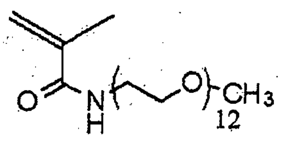

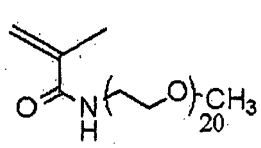 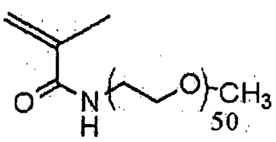 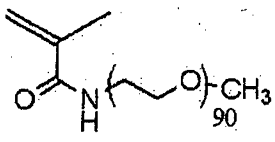

The amount of the polyethyleneoxy group in the fine particle of polymer is preferably from 3.0 to 90% by weight, more preferably from 5.0 to 70% by weight, and particularly preferably from 5.0 to 60% by weight.

The fine particle of polymer may have a crosslinking property in order to improve the film strength of the image area. In order to impart the crosslinking property to the polymer, a crosslinkable functional group, for example, an ethylenically unsaturated bond is introduced into a main chain or side chain of the polymer. The crosslinkable functional group may be introduced by copolymerization.

Examples of the polymer having an ethylenically unsaturated bond in the main chain thereof include poly-1,4-butadiene and poly-1,4-isoprene.

Examples of the polymer having an ethylenically unsaturated bond in the side chain thereof include a polymer of an ester or amide of acrylic acid or methacrylic acid, which is a polymer wherein the ester or amido residue (R in -COOR or -CONHR) has an ethylenically unsaturated bond.

Examples of the residue (R described above) having an ethylenically unsaturated bond include $-(CH2)_nCR^1=CR^2R^3$, $-(CH_2O)_nCH_2CR^1=CR^2R^3$, $-(CH_2CH_2O)_nCH_2CR^1=CR^2R^3$, $-(CH_2)_nNH-CO-O-CH_2CR^1=CR^2R^3$, $-(CH_2)_n-O-CO-CR^1=CR^2R^3$ and $-(CH_2CH_2O)_2-X$ (wherein $R^1$ to $R_3$ each represents a hydrogen atom, a halogen atom or an alkyl group having from 1 to 20 carbon atoms, an aryl group, an alkoxy group or an aryloxy group, or $R^1$ and $R^2$ or $R^1$ and $R^3$ may be combined with each other to form a ring. n represents an integer from 1 to 10. X represents a dicyclopentadienyl residue).

Specific examples of the ester residue include $-CH_2CH=CH_2$ (described in JP-B-7-21633), $-CH_2CH_2O-CH_2CH=CH_2$, $-CH_2C(CH_3)=CH_2$, $-CH_2CH=CH-C_6H_5$, $-CH_2CH_2OCOCH=CH-C_6H_5$, $-CH_2CH_2-NHCOO-CH_2CH=CH_2$ and $-CH_2CH_2O-X$ (wherein X represents a dicyclopentadienyl residue).

Specific examples of the amido residue include $-CH_2CH=CH_2$, $-CH_2CH_2-Y$ (wherein Y represents a cyclohexene residue) and $-CH_2CH_2-OCO-CH=CH_2$.

The content of the crosslinkable group (content of the radical polymerizable unsaturated double bond determined by iodine titration) in the fine particle of polymer is preferably from 0.1 to 10.0 mmol, more preferably from 1.0 to 7.0 mmol, most preferably from 2.0 to 5.5 mmol, per g of the polymer. In the range described above, good sensitivity and good preservation stability can be obtained.

As other copolymerizable monomer for use in the synthesis of fine particle of polymer according to the invention, monomers (m1) to (m11) described with respect to the star polymer can be used.

The fine particle of polymer according to the invention can be obtained, for example, by emulsion polymerization or suspension polymerization of the monomer having a polyethyleneoxy group described above or the like.

Specific examples (1) to (13) of the vinyl resin forming the fine particle of polymer which can be used in the invention are set forth below, but the invention should not be construed as being limited thereto. The copolymerization ratio is indicated as a molar ratio.

(1) 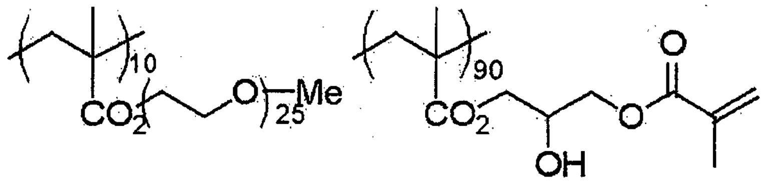

(2) 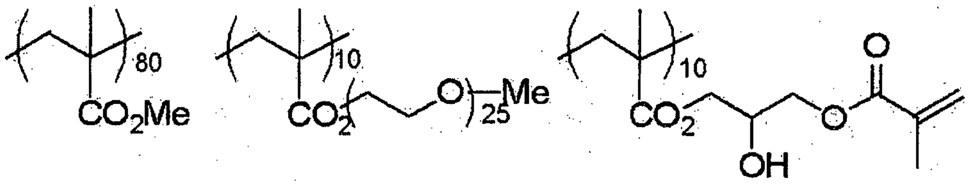

(3) 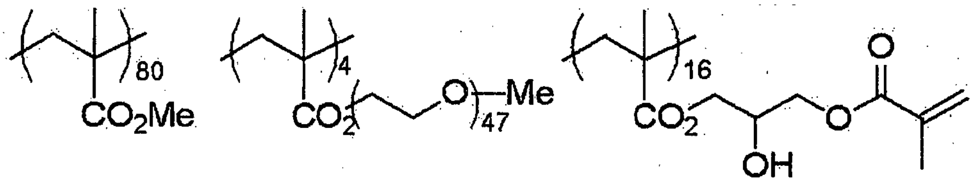

(4) 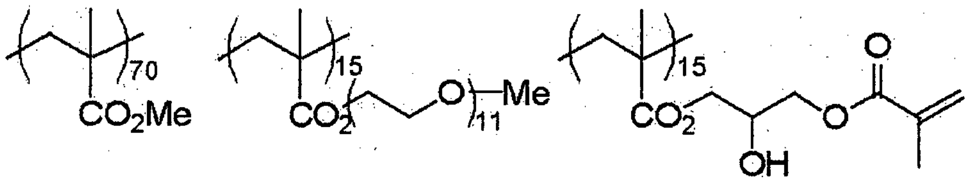

(5) 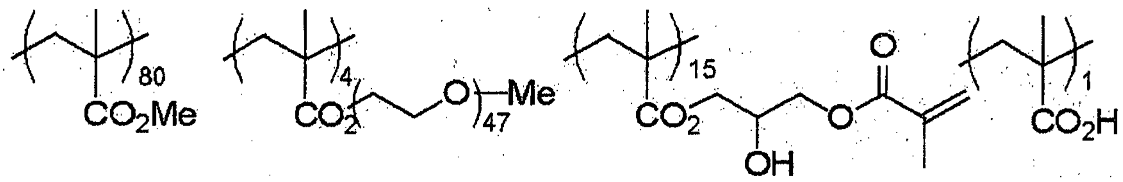

(6) 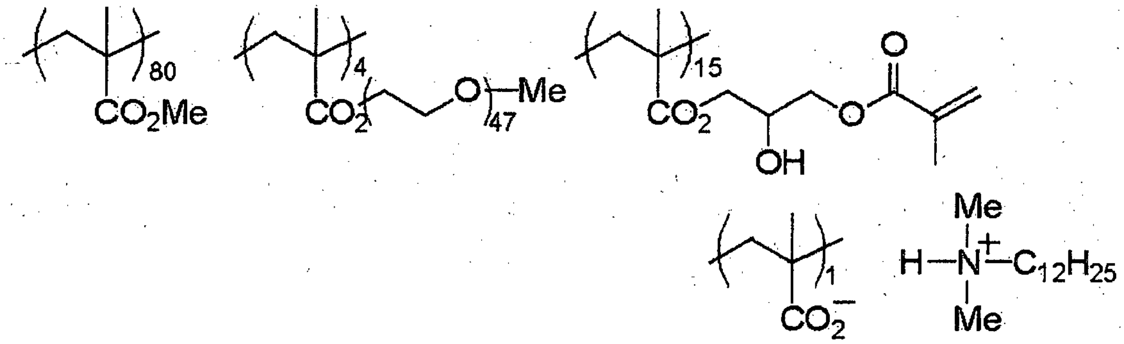

(7) 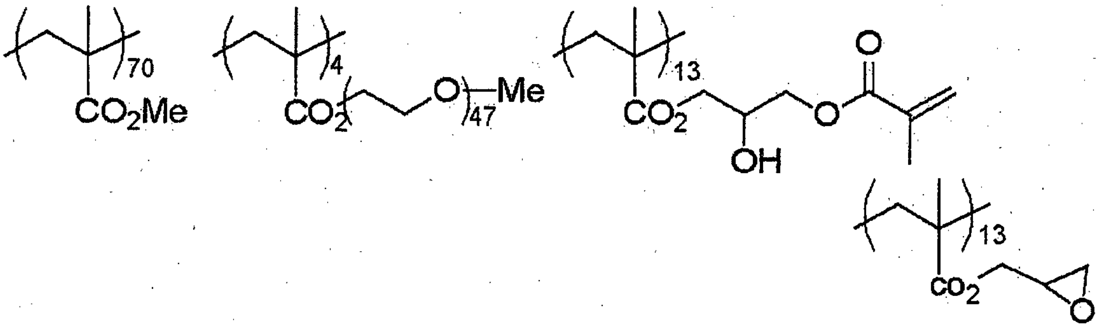

(8) 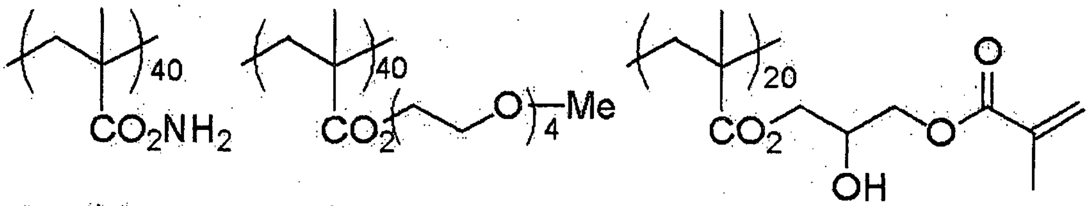

(9) 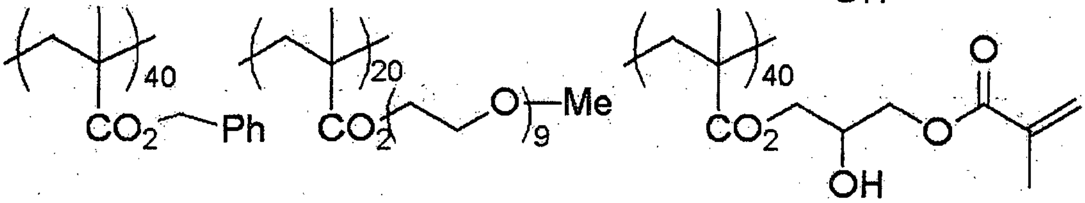

(10) 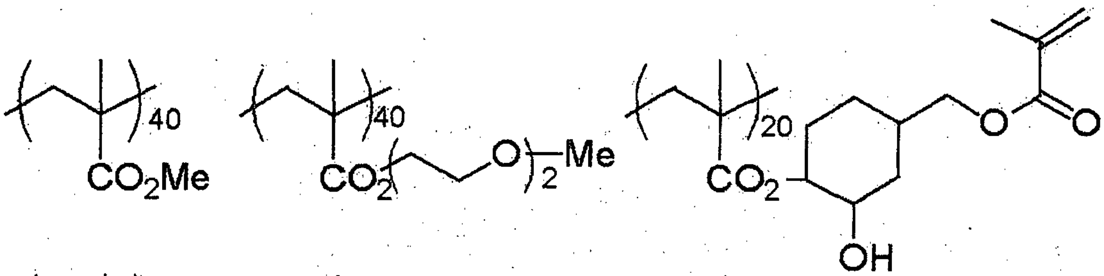

(11) 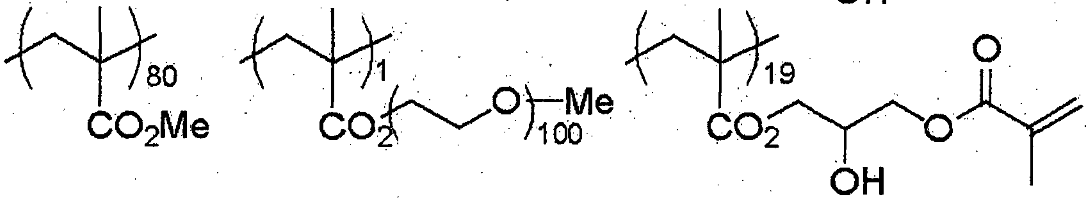

(12) 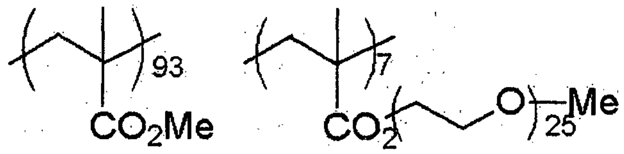

(13) 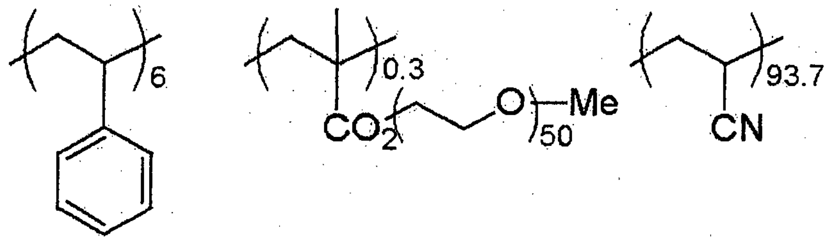

The weight average molecular weight (Mw) of the fine particle of polymer according to the invention is preferably 2,000 or more, more preferably 5,000 or more, and still more preferably 10,000 or more.

The average particle size of the fine particle of polymer according to the invention is preferably in a range from 10 to 1,000 nm, more preferably in a range from 20 to 300 nm, and particularly preferably in a range from 30 to 120 nm.

The content of the of the fine particle of polymer according to the invention is preferably from 10 to 90% by weight, more preferably from 10 to 80% by weight, particularly preferably from 15 to 70% by weight, based on the total solid content of the image-recording layer.

[Polymerizable compound]

The polymerizable compound for use in the invention is an addition-polymerizable compound having at least one ethylenically unsaturated double bond and it is selected from compounds having at least one, preferably two or more, terminal ethylenically unsaturated double bonds. The polymerizable compound has a chemical form, for example, a monomer, a prepolymer, specifically, a dimer, a trimer or an oligomer, or a mixture thereof.

Examples of the monomer include an unsaturated carboxylic acid (for example, acrylic acid, methacrylic acid, itaconic acid, crotonic acid, isocrotonic acid or maleic acid) and an ester or amide thereof. Preferably, an ester of an unsaturated carboxylic acid with a polyhydric alcohol compound and an amide of an unsaturated carboxylic acid with a polyvalent amine compound are used. An addition reaction product of an unsaturated carboxylic acid ester or amide having a nucleophilic substituent, for example, a hydroxy group, an amino group or a mercapto group, with a monofunctional or polyfunctional isocyanate or epoxy compound, or a dehydration condensation reaction product of an unsaturated carboxylic acid ester or amide with a monofunctional or polyfunctional carboxylic acid is also preferably used. Moreover, an addition reaction product of an unsaturated carboxylic acid ester or amide having an electrophilic substituent, for example, an isocyanate group or an epoxy group with a monofunctional or polyfunctional alcohol, amine or thiol, or a substitution reaction product of an unsaturated carboxylic acid ester or amide having a releasable substituent, for example, a halogen group or a tosyloxy group with a monofunctional or polyfunctional alcohol, amine or thiol is also preferably used. In addition, compounds in which the unsaturated carboxylic acid described above is replaced by an unsaturated phosphonic acid, styrene, vinyl ether or the like can also be used. These compounds are described in references including JP-T-2006-508380, JP-A-2002-287344, JP-A-2008-256850, JP-A-2001-342222, JP-A-9-179296, JP-A-9-179297, JP-A-9-179298, JP-A-2004-294935, JP-A-2006-243493, JP-A-2002-275129, JP-A-2003-64130, JP-A-2003-280187 and JP-A-10-333321.

Specific examples of the monomer, which is an ester of a polyhydric alcohol compound with an unsaturated carboxylic acid, include, as an acrylic acid ester, for example, ethylene glycol diacrylate, 1,3-butanediol diacrylate, tetramethylene glycol diacrylate, propylene glycol diacrylate, trimethylolpropane triacrylate, hexanediol diacrylate, tetraethylene glycol diacrylate, pentaerythritol tetraacrylate, sorbitol triacrylate, isocyanuric acid ethylene oxide (EO) modified triacrylate and polyester acrylate oligomer. As a methacrylic acid ester, for example, tetramethylene glycol dimethacrylate, neopentyl glycol dimethacrylate, trimethylolpropane trimethacrylate, ethylene glycol dimethacrylate, pentaerythritol trimethacrylate, bis[p-(3-methacryloxy-2-hydroxypropoxy)phenyl]dimethylmethane and bis[p-(methacryloxyethoxy)phenyl]dimethylmethane are exemplified. Specific examples of the monomer, which is an amide of a polyvalent amine compound with an unsaturated carboxylic acid, include methylene bisacrylamide, methylene bismethacrylamide, 1,6-hexamethylene bisacrylamide, 1,6-hexamethylene bismethacrylamide, diethylenetriamine trisacrylamide, xylylene bisacrylamide and xylylene bismethacrylamide.

Urethane type addition-polymerizable compounds produced using an addition reaction between an isocyanate and a hydroxy group are also preferably used and specific examples thereof include vinylurethane compounds having

two or more polymerizable vinyl groups per molecule obtained by adding a vinyl monomer containing a hydroxy group represented by formula (A) shown below to a polyisocyanate compound having two or more isocyanate groups per molecule, described in JP-B-48-41708.

$$CH_2=C(R^4)COOCH_2CH(R^5)OH \qquad (A)$$

wherein $R^4$ and $R^5$ each independently represents H or $CH_3$.

Also, urethane acrylates as described in JP-A-51-37193, JP-B-2-32293, JP-B-2-16765, JP-A-2003-344997 and JP-A-2006-65210, urethane compounds having an ethylene oxide skeleton described in JP-B-58-49860, JP-B-56-17654, JP-B-62-39417, JP-B-62-39418, JP-A-2000-250211 and JP-A-2007-94138, and urethane compounds having a hydrophilic group described in U.S. Patent 7,153,632, JP-T-8-505958, JP-A-2007-293221 and JP-A-2007-293223 are preferably used.

Of the compounds described above, an isocyanuric acid ethyleneoxide-modified acrylate, for example, tris(acryloyloxyethyl) isocyanurate or bis(acryloyloxyethyl) hydroxyethyl isocyanurate is particularly preferred from the standpoint of excellent balance between hydrophilicity relating to the on-press development property and polymerization ability relating to the printing durability.

Details of the method of using the polymerizable compound, for example, selection of the structure, individual or combination use or an amount added, can be appropriately determined in accordance with the characteristic design of the lithographic printing plate precursor. The polymerizable compound according to the invention is used preferably in a range from 1 to 75% by weight, more preferably in a range from 3 to 70% by weight, particularly preferably in a range from 5 to 60% by weight, based on the total solid content of the image-recording layer.

[Polymerization initiator]

The polymerization initiator for use in the invention indicates a compound which initiates or accelerates polymerization of a polymerizable compound. The polymerization initiator which can be used in the invention is preferably a radical polymerization initiator and includes, for example, known thermal polymerization initiators, compounds containing a bond having small bond dissociation energy and photopolymerization initiators.

The polymerization initiator according to the invention include, for example, (a) an organic halide, (b) a carbonyl compound, (c) an azo compound, (d) an organic peroxide, (e) a metallocene compound, (f) an azide compound, (g) a hexaarylbiimidazole compound, (h) an organic borate compound, (i) a disulfone compound, (j) an oxime ester compound and (k) an onium salt compound.

As the organic halide (a), compounds described in Paragraph Nos. [0022] to [0023] of JP-A-2008-195018 are preferred.

As the carbonyl compound (b), compounds described in Paragraph No. [0024] of JP-A-2008-195018 are preferred.

As the azo compound (c), for example, azo compounds described in JP-A-8-108621 can be used.

As the organic peroxide (d), for example, compounds described in Paragraph No. [0025] of JP-A-2008-195018 are preferred.

As the metallocene compound (e), for example, compounds described in Paragraph No. [0026] of JP-A-2008-195018 are preferred.

As the azide compound (f), a compound, for example, 2,6-bis(4-azidobenzylidene)-4-methylcyclohexanone is exemplified.

As the hexaarylbiimidazole compound (g), for example, compounds described in Paragraph No. [0027] of JP-A-2008-195018 are preferred.

As the organic borate compound (h), for example, compounds described in Paragraph No. [0028] of JP-A-2008-195018 are preferred.

As the disulfone compound (i), for example, compounds described in JP-A-61-166544 and JP-A-2002-328465 are exemplified.

As the oxime ester compound (j), for example, compounds described in Paragraph Nos. [0028] to [0030] of JP-A-2008-195018 are preferred.

As the onium salt compound (k), onium salts, for example, diazonium salts described in S. I. Schlesinger, Photogr. Sci. Eng., 18, 387 (1974), T. S. Bal et al., Polymer, 21, 423 (1980) and JP-A-5-158230 (corresponding to diazonium of NI3), ammonium salts described in U.S. Patent 4,069,055 and JP-A-4-365049, phosphonium salts described in U.S. Patents 4,069,055 and 4,069,056, iodonium salts described in European Patent 104,143, U. S. Patent Publication No. 2008/0311520, JP-A-2-150848, JP-A-2008-195018 and J. V. Crivello et al., Macromolecules, 10 (6), 1307 (1977), sulfonium salts described in European Patents 370,693, 233,567, 297,443 and 297,442, U.S. Patents 4,933,377, 4,760,013, 4,734,444 and 2,833,827 and German Patents 2,904,626, 3,604,580 and 3,604,581, selenonium salts described in J. V. Crivello et al., J. Polymer Sci., Polymer Chem. Ed., 17, 1047 (1979), arsonium salts described in C. S. Wen et al., Teh, Proc. Conf. Rad. Curing ASIA, p. 478, Tokyo, Oct. (1988), and azinium salts described in JP-A-2008-195018 are exemplified.

Of the polymerization initiators described above, the onium salt, in particular, the iodonium salt, the sulfonium salt or the azinium salt is more preferred. Specific examples of these compounds are set forth below, but the invention should not be construed as being limited thereto.

Of the iodonium salts, a diphenyliodonium salt is preferred. In particular, a diphenyliodonium salt substituted with an electron donating group, for example, an alkyl group or an alkoxy group is preferred, and an asymmetric diphenyliodonium salt is more preferred. Specific examples of the iodonium salt include diphenyliodonium hexafluorophosphate, 4-methoxyphenyl-4-(2-methylpropyl)phenyliodonium hexafluorophosphate, 4-(2-methylpropyl)phenyl-p-tolyliodonium hexafluorophosphate, 4-hexyloxyphenyl-2,4,6-trimethoxyphenyliodonium hexafluorophosphate, 4-hexyloxyphenyl-2,4-diethoxyphenyliodonium tetrafluoroborate, 4-octyloxyphenyl-2,4,6-trimethoxyphenyliodonium 1-perfluorobutanesulfonate, 4-octyloxyphenyl-2,4,6-trimethoxyphenyliodonium hexafluorophosphate and bis(4-tert-butylphenyl)iodonium tetraphenylborate.

Examples of the sulfonium salt include triphenylsulfonium hexafluorophosphate, triphenylsulfonium benzoylformate, bis(4-chlorophenyl)phenylsulfonium benzoylformate, bis(4-chlorophenyl)-4-methylphenylsulfonium tetrafluoroborate, tris(4-chlorophenyl)sulfonium 3,5-bis(methoxycarbonyl)benzenesulfonate and tris(4-chlorophenyl)sulfonium hexafluorophosphate.

Examples of the azinium salt include 1-cyclohexylmethyloxypyridinium hexafluorophosphate, 1-cyclohexyloxy-4-phenylpyridinium hexafluorophosphate, 1-ethoxy-4-phenylpyridinium hexafluorophosphate, 1-(2-ethylhexyloxy)-4-phenylpyridinium hexafluorophosphate, 4-chloro-1-cyclohexylmethyloxypyridinium hexafluorophosphate, 1-ethoxy-4-cyanopyridinium hexafluorophosphate, 3,4-dichloro-1-(2-ethylhexyloxy)pyridinium hexafluorophosphate, 1-benzyloxy-4-phenylpyridinium hexafluorophosphate, 1-phenethyloxy-4-phenylpyridinium hexafluorophosphate, 1-(2-ethylhexyloxy)4-phenylpyridinium p-toluenesulfonate, 1-(2-ethylhexyloxy)-4-phenylpyridinium perfluorobutanesulfonate, 1-(2-ethylhexyloxy)-4-phenylpyridinium bromide and 1-(2-ethylhexyloxy)-4-phenylpyridinium tetrafluoroborate.

The polymerization initiator according to the invention can be added preferably in an amount from 0.1 to 50% by weight, more preferably from 0.5 to 30% by weight, particularly preferably from 0.8 to 20% by weight, based on the total solid content constituting the image-recording layer. In the range described above, good sensitivity and good stain resistance in the non-image area at the time of printing are obtained.

[Other components for use in image-recording layer]

To the image-recording layer of the lithographic printing plate precursor according to the invention may be added an infrared absorbing agent, a hydrophilic low molecular weight compound, an oil-sensitizing agent and the like in addition to the components described above.

(Infrared absorbing agent)

The image-recording layer according to the invention preferably contains an infrared absorbing agent in order to increase a polymerization initiation function at the time of infrared laser exposure. The infrared absorbing agent has a function of converting the infrared ray absorbed to heat and a function of being excited by the infrared ray to perform electron transfer and/or energy transfer to a polymerization initiator. As the infrared absorbing agent according to the invention, a dye or pigment having an absorption maximum in a wavelength range from 760 to 1,200 nm is used.

As the infrared absorbing dye, commercially available dyes and known dyes described in literatures, for example, Senryo Binran, compiled by The Society of Synthetic Organic Chemistry, Japan (1970) can be used. Specifically, the dye includes an azo dye, a metal complex azo dye, a pyrazolone azo dye, a naphthoquinone dye, an anthraquinone dye, a phthalocyanine dye, a carbonium dye, a quinoneimine dye, a methine dye, a cyanine dye, a squarylium dye, a pyrylium salt and a metal thiolate complex.

Of the dyes, a cyanine dye, a squarylium dye, a pyrylium salt, a nickel thiolate complex or an indolenine cyanine dye is particularly preferred. A cyanine dye or an indolenine cyanine dye is more preferred. As a particularly preferred example of the dye, a cyanine dye represented by formula (a) shown below is exemplified.

Formula (a)

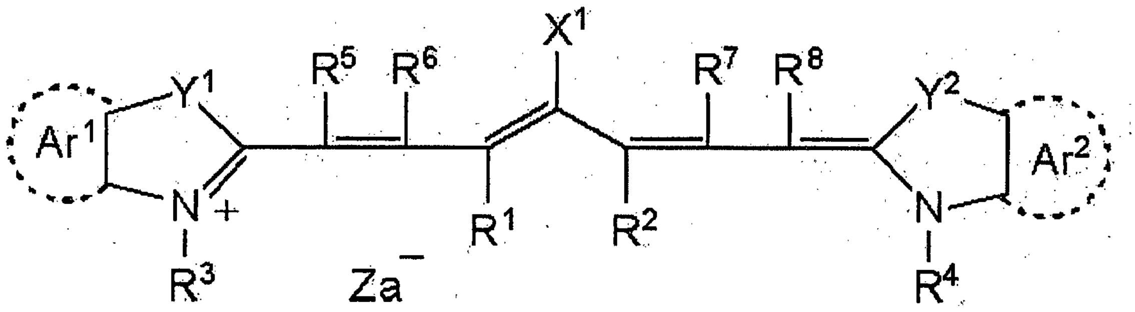

In formula (a), $X^1$ represents a hydrogen atom, a halogen atom, $-NPh_2$, $-X^2-L^1$ or a group shown below. $X^2$ represents an oxygen atom or a sulfur atom. $L^1$ represents a hydrocarbon group having from 1 to 12 carbon atoms, an aromatic ring group containing a hetero atom (a nitrogen atom, a sulfur atom, an oxygen atom, a halogen atom or a selenium atom) or a hydrocarbon group having from 1 to 12 carbon atoms and containing a hetero atom. $Xa^-$ has the same meaning as $Za^-$ defined hereinafter. $R^a$ represents a hydrogen atom or a substituent selected from an alkyl group, an aryl group, a substituted or unsubstituted amino group and a halogen atom.

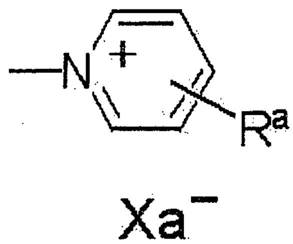

$R^1$ and $R^2$ each independently represents a hydrocarbon group having from 1 to 12 carbon atoms. In view of the preservation stability of a coating solution for image-recording layer, it is preferred that $R^1$ and $R^2$ each represents a hydrocarbon group having two or more carbon atoms. Alternatively, $R^1$ and $R^2$ may be combined with each other to form a ring and in the case of forming a ring, it is particularly preferred that $R^1$ and $R^2$ are combined with each other to form a 5-membered or 6-membered ring.

$Ar^1$ and $Ar^2$, which may be the same or different, each represents an aromatic hydrocarbon group which may have a substituent. Preferred examples of the aromatic hydrocarbon group include a benzene ring group and a naphthalene ring group. Preferred examples of the substituent include a hydrocarbon group having 12 or less carbon atoms, a halogen atom and an alkoxy group having 12 or less carbon atoms. $Y^1$ and $Y^2$, which may be the same or different, each represents a sulfur atom or a dialkylmethylene group having 12 or less carbon atoms. $R^3$ and $R^4$, which may be the same or different, each represents a hydrocarbon group having 20 or less carbon atoms which may have a substituent. Preferred examples of the substituent include an alkoxy group having 12 or less carbon atoms, a carboxyl group and a sulfo group. $R^5$, $R^6$, $R^7$ and $R^8$, which may be the same or different, each represents a hydrogen atom or a hydrocarbon group having 12 or less carbon atoms. In view of the availability of raw materials, a hydrogen atom is preferred. $Za^-$ represents a counter anion. However, $Za^-$ is not necessary when the cyanine dye represented by formula (a) has an anionic substituent in the structure thereof and neutralization of charge is not needed. Preferred examples of the counter ion for $Za^-$ include a halide ion, a perchlorate ion, a tetrafluoroborate ion, a hexafluorophosphate ion and a sulfonate ion, and particularly preferred examples thereof include a perchlorate ion, a hexafluorophosphate ion and an arylsulfonate ion in view of the preservation stability of a coating solution for image-recording layer.

Specific examples of the cyanine dye represented by formula (a), which can be preferably used in the invention, include compounds described in Paragraph Nos. [0017] to [0019] of JP-A-2001-133969.

Further, other particularly preferred examples thereof include specific indolenine cyanine dyes described in JP-A-2002-278057.

As the pigment, commercially available pigments and pigments described in Colour Index (C.I.), Saishin Ganryo Binran compiled by Pigment Technology Society of Japan (1977), Saishin Ganryo Oyou Gijutsu, CMC Publishing Co., Ltd. (1986) and Insatsu Ink Gijutsu, CMC Publishing Co., Ltd. (1984) can be utilized.

The amount of the infrared absorbing agent added is preferably from 0.05 to 30 parts by weight, more preferably from 0.1 to 20 parts by weight, most preferably from 0.2 to 10 parts by weight, per 100 parts by weight of the total solid content of the image-recording layer.

(Hydrophilic low molecular weight compound)

The image-recording layer according to the invention may contain a hydrophilic low molecular weight compound in order to improve the on-press development property without accompanying decrease in the printing durability.

The hydrophilic low molecular weight compound includes a water-soluble organic compound, for example, a glycol, e.g., ethylene glycol, diethylene glycol, triethylene glycol, propylene glycol, dipropylene glycol or tripropylene glycol, or an ether or ester derivative thereof, a polyol, e.g., glycerine, pentaerythritol or tris(2-hydroxyethyl) isocyanurate, an organic amine, e.g., triethanol amine, diethanol amine or monoethanol amine, or a salt thereof, an organic sulfonic acid, e.g., an alkyl sulfonic acid, toluene sulfonic acid or benzene sulfonic acid, or a salt thereof, an organic sulfamic acid, e.g., an alkyl sulfamic acid, or a salt thereof, an organic sulfuric acid, e.g., an alkyl sulfuric acid or an alkyl ether sulfuric acid, or a salt thereof, an organic phosphonic acid, e.g., phenyl phosphonic acid, or a salt thereof, an organic carboxylic acid, e.g., tartaric acid, oxalic acid, citric acid, malic acid, lactic acid, gluconic acid or an amino acid, or a salt thereof and a betaine.

According to the invention, it is preferred that at least one compound selected from a polyol, an organic sulfate, an organic sulfonate and a betaine is incorporated.

Since the hydrophilic low molecular weight compound has a small structure of hydrophobic portion and almost no surface active function, degradations of the hydrophobicity and film strength in the image area due to penetration of dampening water into the exposed area (image area) of the image-recording layer are prevented and thus, the ink receptivity and printing durability of the image-recording layer can be preferably maintained.

The amount of the hydrophilic low molecular weight compound added to the image-recording layer is preferably from 0.5 to 20% by weight, more preferably from 1 to 15% by weight, still more preferably from 2 to 10% by weight, based on the total solid content of the image-recording layer. In the range described above, good on-press development property and good printing durability are achieved.

The hydrophilic low molecular weight compounds may be used individually or as a mixture of two or more thereof.

(Oil-sensitizing agent).

In order to improve the ink receptivity, an oil-sensitizing agent, for example, a phosphonium compound, a nitrogen-containing low molecular weight compound or an ammonium group-containing polymer can be used in the image-recording layer. In particular, in the case where an inorganic stratiform compound is incorporated into a protective layer described hereinafter, the oil-sensitizing agent functions as a surface covering agent of the inorganic stratiform compound and prevents deterioration of the ink receptivity during printing due to the inorganic stratiform compound.

As preferred examples of the phosphonium compound, phosphonium compounds described in JP-A-2006-297907 and JP-A-2007-50660 are exemplified. Specific examples of the phosphonium compound include tetrabutylphosphonium iodide, butyltriphenylphosphonium bromide, tetraphenylphosphonium bromide, 1,4-bis(triphenylphosphonio)butane di(hexafluorophosphate), 1,7-bis(triphenylphosphonio)heptane sulfate and 1,9-bis(triphenylphosphonio)nonane naphthalene-2,7-disulfonate.

As the nitrogen-containing low molecular weight compound, an amine salt and a quaternary ammonium salt are exemplified. Also, an imidazolinium salt, a benzimidazolinium salt, a pyridinium salt and a quinolinium salt are exemplified. Of the nitrogen-containing low molecular weight compounds, the quaternary ammonium salt and pyridinium salt are preferably used. Specific examples the nitrogen-containing low molecular weight compound include tetramethylammonium hexafluorophosphate, tetrabutylammonium hexafluorophosphate, dodecyltrimethylammonium p-toluenesulfonate, benzyltriethylammonium hexafluorophosphate, benzyldimethyloctylammonium hexafluorophosphate, benzyldimethyldodecylammonium hexafluorophosphate and compounds described in Paragraph Nos. [0021] to [0037] of JP-A-2008-284858 and Paragraph Nos. [0030] to [0057] of JP-A-2009-90645.

The ammonium group-containing polymer may be any polymer containing an ammonium group in its structure and is preferably a polymer containing from 5 to 80% by mole of (meth)acrylate having an ammonium group in its side chain as a copolymerization component. Specific examples thereof include compounds described in Paragraph Nos. [0089] to [0105] of JP-A-2009-208458.

As to the ammonium salt-containing polymer, its reduced specific viscosity value (unit: ml/g) determined according to the measuring method described below is preferably in a range from 5 to 120, more preferably in a range from 10 to 110, and particularly preferably in a range from 15 to 100. When the reduced specific viscosity value described above is calculated in terms of weight average molecular weight (Mw), from 10,000 to 150,000 is preferred, from 17,000 to 140,000 is more preferred, and 20,000 to 130,000 is particularly preferred.

<Measuring method of reduced specific viscosity>

In a 20 ml measuring flask was weighed 3.33 g (1 g as a solid content) of a 30% by weight polymer solution

and the measuring flask is filled up to the gauge line with N-methyl pyrrolidone. The resulting solution was allowed to stand in a thermostatic bath of 30°C for 30 minutes and put into an Ubbelohde viscometer (viscometer constant: 0.010 cSt/s) and a period for running down of the solution at 30°C was measured. The measurement was conducted twice for the same sample and an average value of the measurement was determined. The measurement was also conducted for a blank (only N-methyl pyrrolidone) in the same manner. The reduced specific viscosity (ml/g) was calculated according to the formula shown below.

$$\text{Reduced specific viscosity (ml/g)} = \frac{\dfrac{\text{Period for running down of sample solution (sec)} - \text{Period for running down of blank (sec)}}{\text{Period for running down of blank (sec)}}}{\dfrac{1.0\ (\text{g})}{20\ (\text{ml})}}$$

Specific examples of the ammonium group-containing polymer are set forth below.

(1) 2-(Trimethylammonio)ethyl methacrylate p-toluenesulfonate/3,6-dioxaheptyl methacrylate copolymer (molar ratio: 10/90, Mw: 45,000)
(2) 2-(Trimethylammonio)ethyl methacrylate hexafluorophosphate /3,6-dioxaheptyl methacrylate copolymer (molar ratio: 20/80, Mw: 60,000)
(3) 2-(Ethyldimethylammonio)ethyl methacrylate p-toluenesulfonate/hexyl methacrylate copolymer (molar ratio: 30/70, Mw: 45,000)
(4) 2-(Trimethylammonio)ethyl methacrylate hexafluorophosphate /2-ethylhexyl methacrylate copolymer (molar ratio: 20/80, Mw: 60,000)
(5) 2-(Trimethylammonio)ethyl methacrylate methylsulfate/hexyl methacrylate copolymer (molar ratio: 40/60, Mw: 70,000)
(6) 2-(Butyldimethylammonio)ethyl methacrylate hexafluorophosphate/3,6-dioxaheptyl methacrylate copolymer (molar ratio: 25/75, Mw: 65,000)
(7) 2-(Butyldimethylammonio)ethyl acrylate hexafluorophosphate/3,6-dioxaheptyl methacrylate copolymer (molar ratio: 20/80, Mw: 65,000)
(8) 2-(Butyldimethylammonio)ethyl methacrylate 13-ethyl-5,8,11-trioxa-1-heptadecanesulfonate/3,6-dioxaheptyl methacrylate copolymer (molar ratio: 20/80, Mw: 75,000)
(9) 2-(Butyldimethylammonio)ethyl methacrylate hexafluorophosphate/3,6-dioxaheptyl methacrylate/2-hydroxy-3-methacryloyloxypropyl methacrylate copolymer (molar ratio: 15/80/5, Mw: 65,000)

The content of the oil-sensitizing agent is preferably from 0.01 to 30.0% by weight, more preferably from 0.1 to 15.0% by weight, still more preferably from 1 to 10% by weight, based on the total solid content of the image-recording layer.

(Other components)

Other components, for example, a surfactant, a coloring agent, a print-out agent, a polymerization inhibitor, a higher fatty acid derivative, a plasticizer, a fine inorganic particle, an inorganic stratiform compound, a co-sensitizer or a chain transfer agent may further be added to the image-recording layer. Specifically, compounds and amounts added thereof described, for example, in Paragraph Nos. [0114] to [0159] of JP-A-2008-284817, Paragraph Nos. [0023] to [0027] of JP-A-2006-91479 and Paragraph No. [0060] of U.S. Patent Publication No. 2008/0311520 are preferably used.

[Formation of image-recording layer]

The image-recording layer according to the invention is formed by dispersing or dissolving each of the necessary components described above in a known solvent to prepare a coating solution and coating the solution on a support by a known method, for example, bar coater coating and drying as described, for example, in Paragraph Nos. [0142] to [0143] of JP-A-2008-195018. The coating amount (solid content) of the image-recording layer formed on the support after coating and drying may be varied according to the intended purpose but is in general preferably from 0.3 to 3.0 g/m$^2$. In the range described above, good sensitivity and good film property of the image-recording layer can be achieved.

[Undercoat layer]

In the lithographic printing plate precursor according to the invention, it is preferred to provide an undercoat layer (also referred to as an intermediate layer) between the image-recording layer and the support. The undercoat layer strengthens adhesion between the support and the image-recording layer in the exposed area and makes removal of the image-recording layer from the support in the unexposed area easy, thereby contributing improvement in the development property without accompanying degradation of the printing durability. Further, in the case of infrared laser exposure, since the undercoat layer acts as a heat insulating layer, decrease in sensitivity due to diffusion of heat generated upon the exposure into the support is prevented.

As a compound for use in the undercoat layer, a compound having an adsorbing group capable of adsorbing to a surface of support and a crosslinkable group for improving an adhesion property to the image-recording layer is preferred. Further, a compound having a hydrophilicity-imparting group, for example, a sulfo group is also exemplified as a preferable compound. The compound may be a low molecular weight compound or a polymer compound. The compounds may be used in mixture of two or more thereof, if desired.

As the polymer compound, a copolymer of a monomer having an adsorbing group, a monomer having a hydrophilic group and a monomer having a crosslinkable group is preferred. As the adsorbing group capable of adsorbing to a surface of support, a phenolic hydroxy group, a carboxyl group, $-PO_3H_2$, $-OPO_3H_2$, $-CONHSO_2-$, $-SO_2NHSO_2-$ or $-COCH_2COCH_3$ is preferred. As the hydrophilic group, a sulfo group is preferred. As the crosslinkable group, for example, a methacryl group or an allyl group is preferred. The polymer compound may contain a crosslinkable group introduced by a salt formation between a polar substituent of the polymer compound and a compound containing a substituent having a counter charge to the polar substituent of the polymer compound and an ethylenically unsaturated bond and may also be further copolymerized with a monomer other than those described above, preferably a hydrophilic monomer.

Specifically, a silane coupling agent having an addition-polymerizable ethylenic double bond reactive group described in JP-A-10-282679 and a phosphorus compound having an ethylenic double bond reactive group described in JP-A-2-304441 are preferably exemplified. Low molecular weight compounds or polymer compounds having a crosslinkable group (preferably an ethylenically unsaturated bond group), a functional group capable of interacting with a surface of support and a hydrophilic group described in JP-A-2005-238816, JP-A-2005-125749, JP-A-2006-239867 and JP-A-2006-215263 are also preferably used.

Polymer compounds having an adsorbing group capable of adsorbing to a surface of support, a hydrophilic group and a crosslinkable group described in JP-A-2005-125749 and JP-A-2006-188038 are more preferred.

The content of the unsaturated double bond in the polymer compound for undercoat layer is preferably from 0.1 to 10.0 mmol, most preferably from 0.2 to 5.5 mmol, based on 1 g of the polymer compound.

The weight average molecular weight of the polymer compound for undercoat layer is preferably 5,000 or more, and more preferably from 10,000 to 300,000.

The undercoat layer according to the invention may contain a chelating agent, a secondary or tertiary amine, a polymerization inhibitor or a compound containing an amino group or a functional group having polymerization inhibition ability and a group capable of interacting with a surface of aluminum support (for example, 1,4-diazabicyclo[2,2,2]octane (DABCO), 2,3,5,6-tetrahydroxy-p-quinone, chloranil, sulfophthalic acid, hydroxyethylethylenediaminetriacetic acid, dihydroxyethylethylenediaminediacetic acid or hydroxyethyliminodiacetic acid) in addition to the compound for the undercoat layer described above in order to prevent the occurrence of stain due to the lapse of time.

The undercoat layer is coated according to a known method. The coating amount (solid content) of the undercoat layer is preferably from 0.1 to 100 $mg/m^2$, and more preferably from 1 to 30 $mg/m^2$.

[Support]

As the support for use in the lithographic printing plate precursor according to the invention, a known support having a hydrophilic surface is employed. Particularly, an aluminum plate subjected to roughening treatment and anodizing treatment according to a known method is preferred.

Also, an enlarging treatment or a sealing treatment of micropores of the anodized film described in JP-A-2001-253181 and JP-A-2001-322365 or a surface hydrophilizing treatment, for example, with an alkali metal silicate as described in U.S. Patents 2,714,066, 3,181,461, 3,280,734 and 3,902,734 or polyvinyl phosphonic acid as described in U.S. Patents 3,276,868, 4,153,461 and 4,689,272 may be appropriately selected and applied to the aluminum plate, if desired.

The support preferably has a center line average roughness of 0.10 to 1.2 $\mu m$.

The support may have a backcoat layer containing an organic polymer compound described in JP-A-5-45885 or an alkoxy compound of silicon described in JP-A-6-35174, provided on the back surface thereof, if desired.

[Protective layer]

In the lithographic printing plate precursor according to the invention, it is preferred to provide a protective layer (overcoat layer) on the image-recording layer. The protective layer has a function for preventing, for example, occurrence of scratch in the image-recording layer or ablation caused by exposure with a high illuminance laser beam, in addition to the function for restraining an inhibition reaction against the image formation by means of oxygen blocking.

With respect to the protective layer having such properties, there are described, for example, in U.S. Patent 3,458,311 and JP-B-55-49729. As a polymer having low oxygen permeability for use in the protective layer, any water-soluble polymer and water-insoluble polymer can be appropriately selected to use. The polymers may be used in mixture of two or more thereof, if desired. Specifically, for example, polyvinyl alcohol, a modified polyvinyl alcohol, polyvinyl pyrrolidone, a water-soluble cellulose derivative and poly(meth)acrylonitrile are exemplified.

As the modified polyvinyl alcohol, an acid-modified polyvinyl alcohol having a carboxylic acid group or a sulfonic acid group is preferably used. Specifically, modified polyvinyl alcohols described in JP-A-2005-250216 and JP-A-2006-259137 are preferably exemplified.

It is also preferred for the protective layer to contain an inorganic stratiform compound, for example, natural mica or synthetic mica as described in JP-A-2005-119273 in order to increase the oxygen blocking property.

Further, the protective layer may contain a known additive, for example, a plasticizer for imparting flexibility, a surfactant for improving a coating property or a fine inorganic particle for controlling a surface slipping property. The oil-sensitizing agent described with respect to the image-recording layer may also be incorporated into the protective layer.

The protective layer is coated according to a known method. The coating amount of the protective layer is preferably in a range from 0.01 to 10 g/m$^2$, more preferably in a range from 0.02 to 3 g/m$^2$, most preferably in a range from 0.02 to 1 g/m$^2$, in terms of the coating amount after drying.

[Lithographic printing method]

The lithographic printing plate precursor according to the invention is subjected to plate making by performing after image exposure, development processing or development on a printing machine to use printing.

<Image exposure>

The lithographic printing plate precursor is imagewise exposed with laser through a transparent original having a line image, a halftone dot image or the like, or imagewise exposed, for example, by scanning of laser beam based on digital data.

The wavelength of light source is preferably from 750 to 1,400 nm. As the light source of 750 to 1,400 nm, a solid laser or semiconductor laser emitting an infrared ray is preferably used. With respect to the infrared ray laser, the output is preferably 100 mW or more, the exposure time per pixel is preferably within 20 microseconds, and the irradiation energy amount is preferably from 10 to 300 mJ/cm$^2$. Further, in order to reduce the exposure time, it is preferred to use a multibeam laser device. The exposure mechanism may be any of an internal drum system, an external drum system and a flat bed system.

The image exposure can be performed according to a conventional manner by using, for example, a platesetter. In the case of on-press development, after the lithographic printing plate precursor is mounted on a printing machine, the image exposure may be performed on the printing machine.

<Development processing>

The development processing can be performed by (1) method (developer processing process) of developing with a developer having pH from 2 to 14 or (2) method (on-press development process) of developing by supplying dampening water and/or ink on a printing machine.

<Developer processing process>

In the developer processing process, the imagewise exposed lithographic printing plate precursor is processed with a developer having pH from 2 to 14 to remove the unexposed area of the image-recording layer, thereby preparing a lithographic printing plate.

In a development processing using a highly alkaline developer (having pH of 14 or higher), ordinarily, a protective layer is removed in a pre-water washing step, the alkali development is conducted, the alkali is removed by washing with water in a post-water washing step, gum solution treatment is conducted and drying is conducted in a drying step, thereby preparing a lithographic printing plate.

According to a preferred embodiment of the invention, a developer having pH from 8 to 12 is used. In the embodiment, it is preferred to be incorporated a surfactant or a water-soluble polymer compound into the developer so that the development and gum solution treatment step can be conducted at the same time. Thus, the post-water washing step is not particularly necessary, and the development and gum solution treatment can be performed with one solution. Further, the pre-water washing step is not particularly necessary and removal of the protective layer can be conducted at the same time together with the development and gum solution treatment. After the development and gum solution treatment, the excess developer is preferably removed, for example, using a squeeze roller, followed by drying.

The anionic surfactant for use in the developer according to the invention is not particularly limited and includes, for example, fatty acid salts, abietic acid salts, hydroxyalkanesulfonic acid salts, alkanesulfonic acid salts, dialkylsulfosuccinic acid salts, straight-chain alkylbenzenesulfonic acid salts, branched alkylbenzenesulfonic acid salts, alkylnaphthalenesulfonic acid salts, alkyldiphenylether (di)sulfonic acid salts, alkylphenoxy polyoxyethylene propylsulfonic acid salts, polyoxyethylene alkylsulfophenyl ether salts, N-alkyl-N-oleyltaurine sodium salt, N-alkylsulfosuccinic acid monoamide disodium salts, petroleum sulfonic acid salts, sulfated castor oil, sulfated beef tallow oil, sulfate ester slats of fatty acid alkyl ester, alkyl sulfate ester salts, polyoxyethylene alkyl ether sulfate ester salts, fatty acid monoglyceride sulfate ester salts, polyoxyethylene alkyl phenyl ether sulfate ester salts, polyoxyethylene styryl phenyl ether sulfate ester salts, alkyl phosphate ester salts, polyoxyethylene alkyl ether phosphate ester salts, polyoxyethylene alkyl phenyl ether phosphate ester salts, partially saponified products of styrene-maleic anhydride copolymer, partially saponified products of olefin-maleic anhydride copolymer and naphthalene sulfonate formalin condensates. Of the compounds, alkylbenzenesulfonic acid salts, alkylnaphthalenesulfonic acid salts and alkyldiphenylether (di)sulfonic acid salts are particularly preferably used.

The cationic surfactant for use in the developer according to the invention is not particularly limited and hitherto known cationic surfactants may be used. For example, alkylamine salts, quaternary ammonium salts, alkylimidazolinium salts, polyoxyethylene alkyl amine salts and polyethylene polyamine derivatives are exemplified.

The nonionic surfactant for use in the developer according to the is not particularly limited and includes, for example, polyethylene glycol type higher alcohol ethylene oxide adducts, alkylphenol ethylene oxide adducts, alkylnaphthol ethylene oxide adducts, phenol ethylene oxide adducts, naphthol ethylene oxide adducts, fatty acid ethylene oxide adducts, polyhydric alcohol fatty acid ester ethylene oxide adducts, higher alkylamine ethylene oxide adducts, fatty acid amide ethylene oxide adducts, ethylene oxide addacts of fat, polypropylene glycol ethylene oxide adducts, dimethylsiloxane-ethylene oxide block copolymers, dimethylsiloxane-(propylene oxide-ethylene oxide) block copolymers, fatty acid esters of polyhydric alcohol type glycerol, fatty acid esters of pentaerythritol, fatty acid esters of sorbitol and sorbitan, fatty acid esters of sucrose, alkyl ethers of polyhydric alcohols and fatty acid amides of alkanolamines. Of the compounds, those having an aromatic ring and an ethylene oxide chain are preferred, and alkyl-substituted or unsubstituted phenol ethylene oxide adducts and alkyl-substituted or unsubstituted naphthol ethylene oxide adducts are more preferred.

The amphoteric surfactant for use in the developer according to the invention is not particularly limited and includes, for instance, amine oxide type, for example, alkyldimethylamine oxide, betaine type, for example, alkyl betaine and amino acid type, for example, sodium salt of alkylamino fatty acid. In particular, an alkyldimethylamine oxide which may have a substituent, an alkyl carboxy betaine which may have a substituent and an alkyl sulfo betaine which may have a substituent are preferably used. Specifically, compounds represented by formula (2) in Paragraph No. [0256] of JP-A-2008-203359, compounds represented by formulae (I), (II) and (VI) in Paragraph No. [0028] of JP-A-2008-276166 and compounds described in Paragraph Nos. [0022] to [0029] of JP-A-2009-47927 can be used.

Two or more surfactants may be used in the developer. The content of the surfactant contained in the developer is preferably from 0.01 to 20% by weight, and more preferably from 0.1 to 10% by weight.

The water-soluble polymer compound for use in the developer according to the invention includes, for example, soybean polysaccharide, modified starch, gum arabic, dextrin, a cellulose derivative (for example, carboxymethyl cellulose, carboxyethyl cellulose or methyl cellulose) or a modified product thereof, pllulan, polyvinyl alcohol or a derivative thereof, polyvinyl pyrrolidone, polyacrylamide, an acrylamide copolymer, a vinyl methyl ether/maleic anhydride copolymer, a vinyl acetate/maleic anhydride copolymer, a styrene/maleic anhydride copolymer, polyvinylsulfonic acid or a salt thereof and a polystyrenesulfonic acid or a salt thereof.

As the soybean polysaccharide, known soybean polysaccharide can be used. For example, as a commercial product, SOYAFIVE (trade name, produced by Fuji Oil Co., Ltd.) is available and various grade products can be used. The soybean polysaccharide preferably used is that having viscosity in a range from 10 to 100 mPa/sec in the 10% by weight aqueous solution thereof.

As the modified starch, known modified starch can be used. The modified starch can be prepared, for example, by a method wherein starch, for example, of corn, potato, tapioca, rice or wheat is decomposed, for example, with an acid or an enzyme to an extent that the number of glucose residue per molecule is from 5 to 30 and then oxypropylene is added thereto in an alkali.

Two or more water-soluble polymer compounds may be used in combination. The content of the water-soluble polymer compound in the developer is preferably from 0.1 to 20% by weight, and more preferably from 0.5 to 10% by

weight.

Into the developer for use in the invention, a pH buffer agent may be incorporated. A pH buffer agent exhibiting a pH buffer function at pH from 2 to 14 is used without particular restriction in the developer according to the invention. In the invention, a weak alkaline buffer agent is preferably used and includes, for example, (a) a carbonate ion and a hydrogen carbonate ion, (b) a borate ion, (c) a water-soluble amine compound and an ion of the water-soluble amine compound, and combinations thereof. Specifically, for example, (a) a combination of a carbonate ion and a hydrogen carbonate ion, (b) a borate ion, or (c) a combination of a water-soluble amine compound and an ion of the water-soluble amine compound exhibits a pH buffer function in the developer to prevent fluctuation of the pH even when the developer is used for a long period of time. As a result, for example, the deterioration of development property resulting from the fluctuation of pH and the occurrence of development scum are restrained. The combination of a carbonate ion and a hydrogen carbonate ion is particularly preferred.

In order for a carbonate ion and a hydrogen carbonate ion to be present in the developer, a carbonate and a hydrogen carbonate may be added to the developer or a carbonate ion and a hydrogen carbonate ion may be generated by adding a carbonate or a hydrogen carbonate to the developer and then adjusting the pH. The carbonate or hydrogen carbonate used is not particularly restricted and it is preferably an alkali metal salt thereof. Examples of the alkali metal include lithium, sodium and potassium and sodium is particularly preferable. The alkali metals may be used individually or in combination of two or more thereof.

The total amount of the carbonate ion and hydrogen carbonate ion is preferably from 0.05 to 5 mole/l, more preferably from 0.07 to 2 mole/l, particularly preferably from 0.1 to 1 mole/l, in the developer.

The developer according to the invention may contain an organic solvent. As the organic solvent to be contained, for example, an aliphatic hydrocarbon (e.g., hexane, heptane, Isopar E, Isopar H, Isopar G (produced by Esso Chemical Co., Ltd.)), an aromatic hydrocarbon (e.g., toluene or xylene), a halogenated hydrocarbon (methylene dichloride, ethylene dichloride, trichlene or monochlorobenzene) or a polar solvent is exemplified. Examples of the polar solvent include an alcohol (e.g., methanol, ethanol, propanol, isopropanol, 1-butanol, 1-pentanol, 1-hexanol, 1-heptanol, 1-octanol, 2-octanol, 2-ethyl-1-hexanol, 1-nonanol, 1-decanol, benzyl alcohol, ethylene glycol monomethyl ether, 2-ethyoxyethanol, diethylene glycol monoethyl ether, diethylene glycol monohexyl ether, triethylene glycol monomethyl ether, propylene glycol monoethyl ether, propylene glycol monomethyl ether, polyethylene glycol monomethyl ether, polypropylene glycol, tetraethylene glycol, ethylene glycol monobutyl ether, ethylene glycol monobenzyl ether, ethylene glycol monophenyl ether, propylene glycol monophenyl ether, methyl phenyl carbinol, amyl alcohol or methylamyl alcohol), a ketone (e.g., acetone, 2-butanone, ethyl butyl ketone, methyl isobutyl ketone or cyclohexanone), an ester (e.g., ethyl acetate, propyl acetate, butyl acetate, amyl acetate, benzyl acetate, methyl lactate, butyl lactate, ethylene glycol monobutyl acetate, polyethylene glycol monomethyl ether acetate, diethylene glycol acetate, diethyl phthalate or butyl levulinate) and others (e.g., triethyl phosphate, tricresyl phosphate, N-phenylethanolamine, N-phenyldiethanolamine, N-methyldiethanolamine, N-ethyldiethanolamine, 4-(2-hydroxyethyl)morpholine, N,N-dimethylacetamide or N-methylpyrrolidone).

Two or more kinds of the organic solvents may be used in combination in the developer. When the organic solvent is insoluble in water, it may be employed by being solubilized in water using a surfactant or the like. In the case where the developer contains an organic solvent, the concentration of the organic solvent is desirably less than 40% by weight in view of safety and inflammability.

The developer according to the invention may contain a preservative, a chelating agent, a defoaming agent, an organic acid, an inorganic acid, an inorganic salt or the like in addition to the components described above. Specifically, compounds described in Paragraph Nos. [0266] to [0270] of JP-A-2007-206217 are preferably used.

The developer processing of the lithographic printing plate precursor according to the invention is performed in a conventional manner at temperature ordinarily from 0 to 60°C, preferably from about 15 to about 40°C, using, for example, a method wherein the exposed lithographic printing plate precursor is immersed in the developer and rubbed with a brush or a method wherein the developer is sprayed to the exposed lithographic printing plate precursor and the exposed lithographic printing plate precursor is rubbed with a brush.

The development processing with the developer having pH from 2 to 14 according to the invention is preferably performed by an automatic development processor equipped with a supplying means for the developer and a rubbing member. An automatic development processor using a rotating brush roll as the rubbing member is particularly preferred. Further, the automatic development processor is preferably provided with a means for removing the excess developer, for example, a squeeze roller or a drying means, for example, a hot air apparatus, subsequently to the development processing means. Moreover, the automatic development processor may be provided with a pre-heating means for heat treatment of the exposed lithographic printing plate precursor prior to the development processing means.

The developer according to the invention can be used as a developer and a development replenisher for the exposed lithographic printing plate precursor. Also, it is preferably applied to the automatic development processor described above. In the case of conducting the development processing using an automatic development processor, the developer becomes fatigued in accordance with the processing amount, and hence the processing ability may be restored using a replenisher or a fresh developer.

<On-press development process>

In the on-press development process, an oily ink and an aqueous component are supplied to the imagewise exposed lithographic printing plate precursor on a printing machine to remove the non-image area of the image-recording layer, thereby preparing a lithographic printing plate.

Specifically, the lithographic printing plate precursor is imagewise exposed and then mounted on a printing machine as it is without undergoing any development processing or the lithographic printing plate precursor is mounted on a printing machine and then imagewise exposed on the printing machine, and thereafter, when an oily ink and an aqueous component are supplied to the imagewise exposed lithographic printing plate precursor to perform printing, in the non-image area, the uncured image-recording layer is removed by dissolution or dispersion with the oily ink and/or aqueous component supplied to reveal the hydrophilic surface in the area. On the other hand, in the exposed area of the image-recording layer, the image-recording layer cured by the exposure forms the oily ink receptive area having the oleophilic surface. While either the oily ink or aqueous component may be supplied at first on the surface of exposed lithographic printing plate precursor, it is preferred to supply the oily ink at first in view of preventing the aqueous component from contamination with the component of the image-recording layer removed. Thus, the lithographic printing plate precursor is subjected to the on-press development on a printing machine and used as it is for printing a large number of sheets. For the oily ink and aqueous component, printing ink and dampening water for conventional lithographic printing are preferably used respectively.

In the method of preparing a lithographic printing plate from the lithographic printing plate precursor according to the invention, regardless of the development process used, the lithographic printing plate precursor may be heated its entire surface before or during the exposure or between the exposure and the development, if desired. By the heating, the image-forming reaction in the image-recording layer is accelerated and advantages, for example, improvement in the sensitivity and printing durability and stabilization of the sensitivity are achieved. Further, in the developer processing process, for the purpose of increasing the image strength and printing durability, it is also effective to perform entire after-heating or entire exposure of the image after the development processing. Ordinarily, the heating before the development is preferably performed under a mild condition of 150°C or lower. When the temperature is too high, a problem may arise sometimes in that the non-image area is also cured. On the other hand, the heating after the development can be performed using very strong conditions. Ordinarily, the heat treatment is carried out in a temperature range from 100 to 500°C. When the temperature is too low, a sufficient effect of strengthening the image may not be obtained, whereas when it is excessively high, problems of deterioration of the support and thermal decomposition of the image area may occur sometimes.

EXAMPLE

The present invention will be described in more detail with reference to the following examples, but the invention should not be construed as being limited thereto. With respect to the polymer compound used in the examples, unless otherwise particularly defined, a molecular weight means a weight average molecular weight (Mw) and a ratio of repeating unit is indicated in mole percent.

[Synthesis example of star polymer]

<u>Synthesis of Star polymer (P-1)</u>

To 330 g of 1-methoxy-2-propanol heated at 80°C under nitrogen stream was dropwise added a mixed solution composed of 101 g of BLEMMER PME-100 (methoxypolyethylene glycol monomethacrylate (repeating unit number of ethylene glycol: 2), produced by NOF Corp.), 125 g of methyl methacrylate, 2.3 g of pentaerythritol tetrakis(mercaptoacetate), 2.4 g of V-601 (dimethyl-2,2'-azobis(2-methylpropionate), produced by Wako Pure Chemical Industries, Ltd.) and 330 g of 1-methoxy-2-propanol over a period of 2 hours and 30 minutes. After the completion of the dropwise addition, the reaction was further continued for 3 hours. After the reaction, the reaction mixture was poured into 4,000 g of water with well stirring to deposit a solid. The solid deposited was collected by filtration, washed with water and dried under a reduced pressure to obtain Star polymer (P-1) represented by the structural formula described hereinbefore. The weight average molecular weight (Mw) of the resulting star polymer determined by GPC of a solution of Star polymer (P-1) represented by the structural formula described hereinbefore was 35,000.

Star polymers (P-2) to (P-10), (P-21) to (P-25) and (P-32) were synthesized in a manner similar to Star polymer (P-1).

Synthesis of Star polymer (P-11)

To 330 g of 1-methoxy-2-propanol heated at 80°C under nitrogen stream was dropwise added a mixed solution composed of 188 g of BLEMMER PME-100, 125 g of methyl methacrylate, 21.5 g of methacrylic acid, 2.3 g of pentaerythritol tetrakis(mercaptoacetate), 2.4 g of V-601 (produced by Wako Pure Chemical Industries, Ltd.) and 330 g of 1-methoxy-2-propanol over a period of 2 hours and 30 minutes. After the completion of the dropwise addition, 0.143 g of V-601 was further added and the temperature was raised to 90°C, followed by continuing to react for 2 hours. After the reaction, the reaction solution was cooled to 50°C and diluted by adding 145.66 g of 1-methoxy-2-propanol. To the resulting reaction mixture were added a mixed solution composed of 0.971 g of 4-hydroxy-2,2,6,6-tetramethylpiperidine-1-oxide, free radical, 35.5 g of glycidyl methacrylate and 13.6 g of 1-methoxy-2-propanol, followed by stirring for 5 minutes. The reaction mixture was raised to 90°C and stirred for 10 minutes, then 2.21 g of tetraethylammonium bromide was added thereto and the tetraethylammonium bromide attached to the wall of the reaction vessel was washed with 30.47 g of 1-methoxy-2-propanol. After stirring at 90°C for 18 hours, 297.0 g of 1-methoxy-2-propanol was added thereto to dilute the reaction mixture. The weight average molecular weight (Mw) of the thus-obtained solution of Star polymer (P-11) represented by the structural formula described hereinbefore measured by GPC was 46,000.
Star polymers (P-12) to (P-20), (P-26) to (P-31) and (P-33) were synthesized in a manner similar to Star polymer (P-11).

[Examples 1 to 13 and Comparative Examples 1 to 4]

[Preparation of Lithographic printing plate precursors (1) to (16)]

(1) Preparation of Support

An aluminum plate (material: JIS A 1050) having a thickness of 0.3 mm was subjected to a degreasing treatment at 50°C for 30 seconds using a 10% by weight aqueous sodium aluminate solution in order to remove rolling oil on the surface thereof and then grained the surface thereof using three nylon brushes embedded with bundles of nylon bristle having a diameter of 0.3 mm and an aqueous suspension (specific gravity: 1.1 g/cm$^3$) of pumice having a median size of 25 $\mu$m, followed by thorough washing with water. The plate was subjected to etching by immersing in a 25% by weight aqueous sodium hydroxide solution of 45°C for 9 seconds, washed with water, then immersed in a 20% by weight nitric acid solution at 60°C for 20 seconds, and washed with water. The etching amount of the grained surface was about 3 g/m$^2$.
Then, using an alternating current of 60 Hz, an electrochemical roughening treatment was continuously carried out on the plate. The electrolytic solution used was a 1% by weight aqueous nitric acid solution (containing 0.5% by weight of aluminum ion) and the temperature of electrolytic solution was 50°C. The electrochemical roughening treatment was conducted using a rectangular alternating current having a trapezoidal waveform such that the time TP necessary for the current value to reach the peak from zero was 0.8 msec and the duty ratio was 1:1, and using a carbon electrode as a counter electrode. A ferrite was used as an auxiliary anode. The current density was 30 A/dm$^2$ in terms of the peak value of the electric current, and 5% of the electric current flowing from the electric source was divided to the auxiliary anode. The quantity of electricity in the nitric acid electrolysis was 175 C/dm$^2$ in terms of the quantity of electricity when the aluminum plate functioned as an anode. The plate was then washed with water by spraying.
The plate was further subjected to an electrochemical roughening treatment in the same manner as in the nitric acid electrolysis above using as an electrolytic solution, a 0.5% by weight aqueous hydrochloric acid solution (containing 0.5% by weight of aluminum ion) having temperature of 50°C and under the condition that the quantity of electricity was 50 C/dm$^2$ in terms of the quantity of electricity when the aluminum plate functioned as an anode. The plate was then washed with water by spraying.
The plate was then subjected to an anodizing treatment using as an electrolytic solution, a 15% by weight aqueous sulfuric acid solution (containing 0.5% by weight of aluminum ion) at a current density of 15 A/dm$^2$ to form a direct current anodized film of 2.5 g/m$^2$, washed with water and dried to prepare Support (1).
Thereafter, in order to ensure the hydrophilicity of the non-image area, Support (1) was subjected to silicate treatment using a 2.5% by weight aqueous sodium silicate No. 3 solution at 60°C for 10 seconds and then washed with water to obtain Support (2). The adhesion amount of Si was 10 mg/m$^2$. The center line average roughness (Ra) of the support was measured using a stylus having a diameter of 2 $\mu$m and found to be 0.51 $\mu$m.

(2) Formation of Undercoat layer

Coating solution (1) for undercoat layer shown below was coated on Support (2) described above so as to have

a dry coating amount of 20 mg/m2 to prepare a support having an undercoat layer.

<Coating solution (1) for undercoat layer>

| | |
|---|---|
| Compound (1) for undercoat layer having structure shown below | 0.18 g |
| Hydroxyethyliminodiacetic acid | 0.10 g |
| Methanol | 55.24 g |
| Water | 6.15 g |

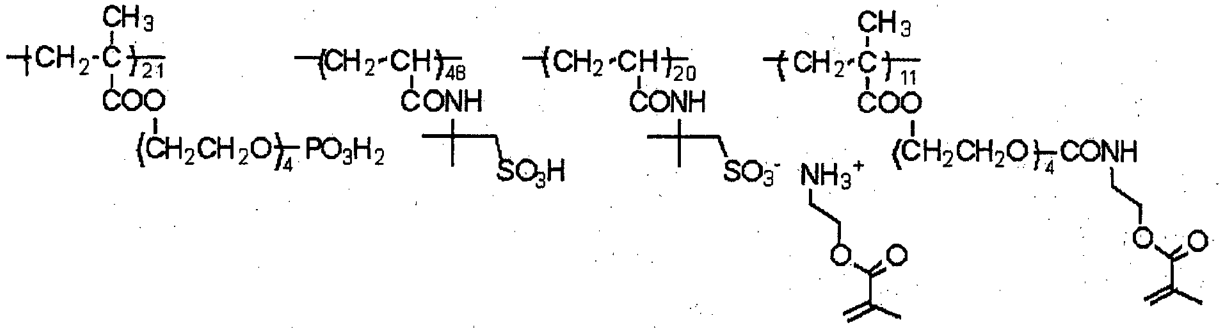

(Mw: 100,000)

Compound (1) for undercoat layer

[Coating of Image-recording layer]

Coating solution (1) for image-recording layer shown below was coated on the support having the undercoat layer described above by a bar and dried in an oven at 70°C for 60 seconds to form an image-recording layer having a dry coating amount of 0.6 g/m2 to prepare each of Lithographic printing plate precursors (1) to (16).

<Coating solution (1) for image-recording layer>

| | |
|---|---|
| Aqueous dispersion of polymer fine particle shown in Table 2 | 4.0 g (as solid content) |
| Infrared absorbing dye (2) having structure shown below | 0.2g |
| Polymerization initiator (IRGACURE 250, produced by BASF) | 0.5 g |
| Polymerizable compound (SR-399, produced by Sartomer Co.) | 1.50 g |
| Mercapto-3-triazole | 0.2 g |
| Polymer compound (star polymer) shown in Table 2 | 4.5 g |
| n-Propanol | 55.0 g |
| 2-Butanone | 17.0 g |

The compounds indicated by using their trade names in the composition described above are shown below.
IRGACURE 250: (4-Methoxyphenyl)[4-(2-methylpropyl)phenyl]iodonium hexafluorophosphate
(75% by weight propylene carbonate solution)
SR-399: Dipentaerythritol pentaacrylate

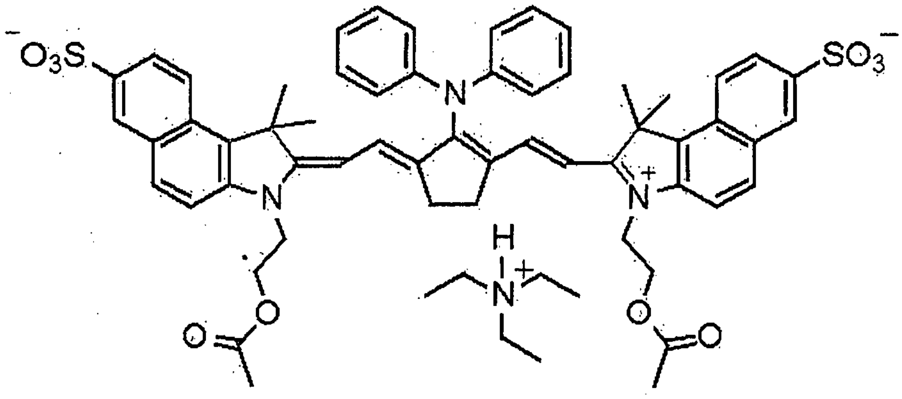

Infrared absorbing dye (2)

(Preparation of Aqueous dispersion (1) of polymer fine particle)

A stirrer, a thermometer, a dropping funnel, a nitrogen inlet tube and a reflux condenser were attached to a 1,000 ml four-neck flask and while carrying out deoxygenation by introduction of nitrogen gas, 10 g of polyethylene glycol methyl ether methacrylate (PEGMA, average repeating unit number of ethylene glycol: 50), 200 g of distilled water and 200 g of n-propanol were charged therein and heated until the internal temperature reached 70°C. Then, a mixture of 10 g of styrene (St), 80 g of acrylonitrile (AN) and 0.8 g of 2,2'-azobisisobutyronitrile previously prepared was dropwise added to the flask over a period of one hour. After the completion of the dropwise addition, the mixture was continued to react as it was for 5 hours. Then, 0.4 g of 2,2'-azobisisobutyronitrile was added and the internal temperature was raised to 80°C. Thereafter, 0.5 g of 2,2'-azobisisobutyronitrile was added over a period of 6 hours. At the stage after reacting for 20 hours in total, the polymerization proceeded 98% or more to obtain Aqueous dispersion (1) of polymer fine particle of PEGMA/St/AN (10/10/80 in a weight ratio). The particle size distribution of the polymer fine particle had the maximum value at the particle size of 150 nm.

The particle size distribution was determined by taking an electron microphotograph of the polymer fine particle, measuring particle sizes of 5,000 fine particles in total on the photograph, and dividing a range from the largest value of the particle size measured to 0 on a logarithmic scale into 50 parts to obtain occurrence frequency of each particle size by plotting. With respect to the aspherical particle, a particle size of a spherical particle having a particle area equivalent to the particle area of the aspherical particle on the photograph was defined as the particle size.

[Preparation of Lithographic printing plate precursor (17)]

Coating solution (1) for protective layer having the composition shown below was further coated on the image-recording layer of Lithographic printing plate precursor (6) described above by a bar and dried in an oven at 120°C for 60 seconds to form a protective layer having a dry coating amount of 0.15 g/$m^2$, thereby preparing Lithographic printing plate precursor (17).

<Coating solution (1) for protective layer>

| | |
|---|---|
| Dispersion of inorganic stratiform compound (1) | 1.5 g |
| Aqueous 6% by weight solution of polyvinyl alcohol (CKS 50, sulfonic acid-modified, saponification degree: 99% by mole or more, polymerization degree: 300, produced by Nippon Synthetic Chemical Industry Co., Ltd.) | 0.55 g |
| Aqueous 6% by weight solution of polyvinyl alcohol (PVA-405, saponification degree: 81.5 % by mole, polymerization degree: 500, produced by Kuraray Co., Ltd.) | 0.03 g |
| Aqueous 1% by weight solution of surfactant (EMALEX 710, produced by Nihon Emulsion Co., Ltd.) | 0.86 g |
| Ion-exchanged water | 6.0 g |

(Preparation of Dispersion of inorganic stratiform compound (1))

To 193.6 g of ion-exchanged water was added 6.4 g of synthetic mica (SOMASIF ME-100, produced by CO-OP Chemical Co., Ltd.) and the mixture was dispersed using a homogenizer until an average particle size (according to a laser scattering method) became 3 μm. The aspect ratio of the inorganic particle thus-dispersed was 100 or more.

[Evaluation of Lithographic printing plate precursor]

(1) On-press development property

The lithographic printing plate precursor obtained was exposed by LUXEL PLATESETTER T-6000III equipped with an infrared semiconductor laser (produced by FUJIFILM Corp.) under the conditions of a rotational number of an external drum of 1,000 rpm, laser output of 70% and resolution of 2,400 dpi. The exposed image contained a solid image and a 50% halftone dot chart of a 20 μm-dot FM screen.

The exposed lithographic printing plate precursor was mounted without undergoing development processing on a plate cylinder of a printing machine (LITHRONE 26, produced by Komori Corp.). Using dampening water (ECOLITY-2 (produced by FUJIFILM Corp.)/tap water = 2/98 (by volume ratio)) and FUSION G EZ Pink N Ink (produced by DIC Corp.), the dampening water and ink were supplied according to the standard automatic printing start method of LITHRONE 26 to conduct on-press development, followed by printing on 100 sheets of TOKUBISHI art paper (76.5 kg) (produced by Mitsubishi Paper Mills Ltd.) at a printing speed of 10,000 sheets per hour.

A number of the printing papers required until the on-press development of the unexposed area of the image-recording layer on the printing machine was completed to reach a state where the ink was not transferred to the printing paper in the non-image area was measured to evaluate the on-press development property. The results obtained are shown in Table 2.

(2) Printing durability

After performing the evaluation for the on-press development property described above, the printing was continued using the lithographic printing plate obtained. As the increase in a number of printing papers, the image-recording layer was gradually abraded to cause decrease in the ink density on a printed material. A number of printed materials wherein a value obtained by measuring a halftone dot area rate of the 50% halftone dot of FM screen on the printed material using a Gretag densitometer decreased by 5% from the value measured on the 100th paper of the printing was determined to evaluate the printing durability. The results obtained are shown in Table 2.

TABLE 2: Examples 1 to 13 and Comparative Examples 1 to 4

| | Lithographic Printing Plate Precursor | Polymer Fine Particle | Polymer Compound (Star Polymer) | Evaluation Results of Printing | |
|---|---|---|---|---|---|
| | | | | Printing Durability (x $10^4$ sheets) | On-press Development Property (sheets) |
| Example 1 | (1) | (1) | P-1 | 3.0 | 20 |
| Example 2 | (2) | (1) | P-2 | 3.0 | 22 |
| Example 3 | (3) | (1) | P-3 | 3.0 | 20 |
| Example 4 | (4) | (1) | P-4 | 3.0 | 20 |
| Example 5 | (5) | (1) | P-5 | 3.0 | 15 |
| Example 6 | (6) | (1) | P-11 | 3.5 | 22 |
| Example 7 | (7) | (1) | P-12 | 3.5 | 24 |
| Example 8 | (8) | (1) | P-13 | 3.5 | 22 |
| Example 9 | (9) | (1) | P-14 | 3.5 | 22 |
| Example 10 | (10) | (1) | P-15 | 3.5 | 18 |
| Example 11 | (11) | (1) | P-32 | 2.8 | 17 |
| Example 12 | (12) | (1) | P-33 | 3.3 | 20 |
| Example 13 | (17) | (1) | P-11 | 4.0 | 25 |

(continued)

| | Lithographic Printing Plate Precursor | Polymer Fine Particle | Polymer Compound (Star Polymer) | Evaluation Results of Printing | |
|---|---|---|---|---|---|
| | | | | Printing Durability (x $10^4$ sheets) | On-press Development Property (sheets) |
| Comparative Example 1 | (13) | (1) | R-1 | 2.8 | 30 |
| Comparative Example 2 | (14) | None | P-11 | 2.8 | 28 |
| Comparative Example 3 | (15) | (1) | R-2 | 2.8 | 28 |
| Comparative Example 4 | (16) | (2) | P-11 | 2.8 | 28 |

Polymer fine particle (2) having no polyethyleneoxy group used in the comparative example above, and Polymer compounds R-1 and R-2 are shown below. The copolymerization ratio is indicated as a molar ratio.

(Preparation of Aqueous dispersion (2) of polymer fine particle)

A stirrer, a thermometer, a dropping funnel, a nitrogen inlet tube and a reflux condenser were attached to a 1,000 ml four-neck flask and while carrying out deoxygenation by introduction of nitrogen gas, 300 ml of distilled water was charged therein and heated until the internal temperature reached 80°C. To the flask was added 1.5 g of sodium dodecylsufate as a dispersing agent, then was added 0.45 g of ammonium persulfate as an initiator, and thereafter were dropwise added 5.0 g of styrene and 40.0 g of acrylonitrile through the dropping funnel over a period of about one hour. After the completion of the dropwise addition, the mixture was continued to react as it was for 5 hours, followed by removing the unreacted monomers by steam distillation. The mixture was cooled, adjusted the pH to 6 with aqueous ammonia and finally added pure water thereto so as to have the nonvolatile content of 15% by weight to obtain Aqueous dispersion (2) of polymer fine particle. The particle size distribution of the polymer fine particle measured in the same manner as in Aqueous dispersion (1) of polymer fine particle had the maximum value at the particle size of 60 nm.

R-1 (Straight-chain polymer having no star-like structure)

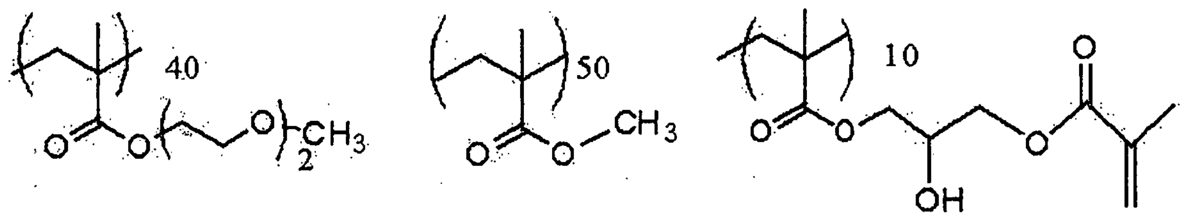

Mw: 100,000

R-2 (Star polymer having hydrophilic group other than polyethyleneoxy chain in its side chain) Mw: 100,000

Structure of branch point

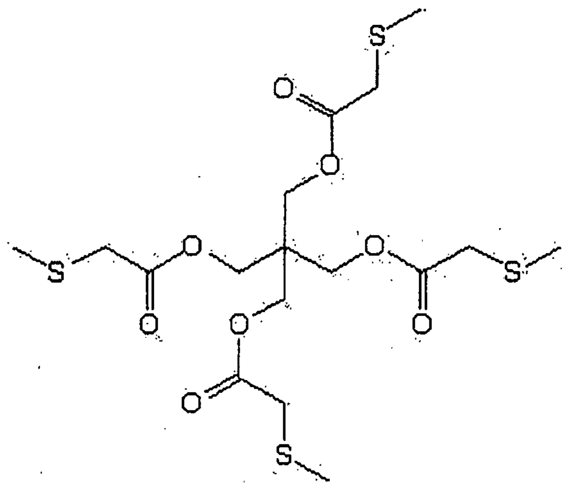

Structure of main chain

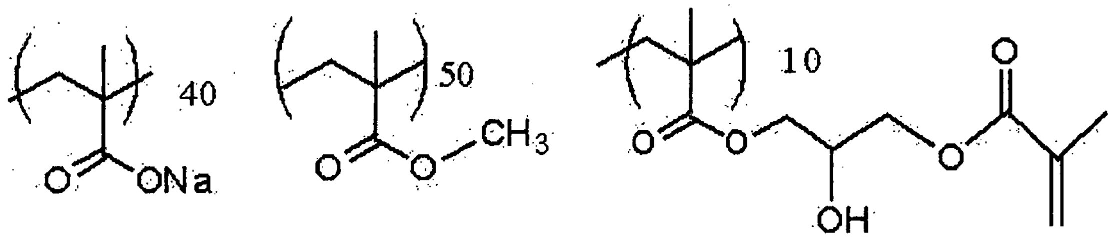

[Examples 14 to 26 and Comparative Examples 5 to 8]

[Plate making of Lithographic printing plate precursor and Printing]

Each of Lithographic printing plate precursors (1) to (17) obtained as described above was exposed by LUXEL PLATESETTER T-6000III equipped with an infrared semiconductor laser (produced by FUJIFILM Corp.) under the conditions of a rotational number of an external drum of 1,000 rpm, laser output of 70% and resolution of 2,400 dpi. The exposed image contained a solid image and a 50% halftone dot chart of a 20 μm-dot FM screen.

The exposed lithographic printing plate precursor was subjected to development processing in an automatic development processor having a structure as shown in Fig. 2 using Developer (1) having the composition shown below. The automatic development processor comprises a developing unit 6 for developing a lithographic printing plate precursor (hereinafter, referred to as a "PS plate") 4 and a drying unit 10 for drying the PS plate 4 after development. An insertion slot is formed in a side plate of the automatic development processor (on the left side in Fig. 2) and the PS plate 4 inserted through the insertion slot is transported into the developing unit 6 by carrying-in rollers 16 provided inside the side plate of the automatic development processor. In a developing tank 20 of the developing unit 6, transport rollers 22, a brush roller 24 and squeeze rollers 26 are provided in order from the upstream side in the transporting direction and backup rollers 28 are disposed in appropriate positions therebetween. The PS plate 4 is immersed in the developer while being transported by the transport rollers 22 and the protective layer and the unexposed area of the image-recording layer of PS plate 4 were removed by rotation of the brush roller 24 to conduct development processing. The PS plate 4 subjected to the development processing is transported into the drying unit 10 by the squeeze rollers (carrying-out rollers) 26. In the drying unit 10, a guide roller 36 and a pair of skewer rollers 38 are disposed in order from the upstream side in the transporting direction. In the drying unit 10, drying means, for example, hot air supply means or heat generating means (not shown) is also provided. A discharge slot is provided in the drying unit 10 and the PS plate 4 dried by the drying means is discharged through the discharge slot, whereby the processing of PS plate by the automatic development processor is completed. The automatic development processor used in the examples had one brush roller having an outer diameter of 50 mm and being implanted with fiber of polybutylene terephthalate (bristle diameter: 200 μm, bristle

length: 17 mm), and the brush roller was rotated at 200 rpm (peripheral velocity at the tip of brush: 0.52 m/sec) in the same direction as the transporting direction of the lithographic printing plate precursor. The temperature of the developer was 30°C. The transportation of the lithographic printing plate precursor was conducted at transporting speed of 82 cm/min (the transporting speed was varied in the evaluation of development property). After the development processing, the lithographic printing plate was dried in the drying unit. The drying temperature was 80°C.

The lithographic printing plate obtained by development was mounted on a printing machine (SOR-M, produced by Heidelberg) and printing was performed at a printing speed of 6,000 sheets per hour using dampening water (ECOLITY-2 (produced by FUJIFILM Corp.)/tap water = 2/98 (by volume ratio)) and FUSION G EZ Pink N Ink (produced by DIC Corp.) on TOKUBISHI art paper (76.5 kg).

(Composition of Developer (1))

The composition of Developer (1) used in the examples and comparative examples are shown in Table 3 below. In the developer, NEWCOL B13 is polyoxyethylene β-naphthyl ether (average number of oxyethylene: n=13, produced by Nippon Nyukazai Co., Ltd.) and gum arabic used has a weight average molecular weight (Mw) of 200,000.

TABLE 3: Developer (1) (pH: 9.8)

| | |
|---|---|
| 0.2 M Aqueous boric acid solution | 25.00 parts by weight |
| 0.2 M Aqueous sodium chloride solution | 25.00 parts by weight |
| 0.1 M Aqueous sodium hydroxide solution | 40.60 parts by weight |
| Water | 9.40 parts by weight |
| NEWCOL B 13 (produced by Nippon Nyukazai Co., Ltd.) | 5.00 parts by weight |
| Gum arabic | 2.50 parts by weight |
| Hydroxy-alkylated starch (PENON JE66, produced by Nippon Starch Chemical Co., Ltd.) | 7.00 parts by weight |

[Evaluation of Lithographic printing plate precursor]

Printing durability and development property were evaluated in the manner described below. The results obtained are shown in Table 4.

<Development property>

With the lithographic printing plates obtained by performing the development while varying the transporting speed, cyan density of the non-image area was measured by a Macbeth densitometer (produced by Gretag Macbeth Co., Ltd.). The transporting speed at which the cyan density of the non-image area became equivalent to cyan density of the aluminum support was determined and at the transporting speed, a time period from when the top of the lithographic printing plate precursor was immersed in the developer to when the top of the lithographic printing plate precursor came out from the developer was regarded as a developing time to evaluate the development property.

<Printing durability>

After performing the evaluation for the development property described above, the printing was further performed using the lithographic printing plate obtained. As the increase in a number of printed materials, the image-recording layer was gradually abraded to cause decrease in the ink density on the printed materials. A number of printed materials wherein a value obtained by measuring a halftone dot area rate of the 50% halftone dot of FM screen on the printed material using a Gretag densitometer decreased by 5% from the value measured on the 100th paper of the printing was determined to evaluate the printing durability. The results obtained are shown in Table 4.

TABLE 4: Examples 14 to 26 and Comparative Examples 5 to 8

| | Lithographic Printing Plate Precursor | Polymer Fine Particle | Polymer Compound (Star Polymer) | Evaluation Results | |
|---|---|---|---|---|---|
| | | | | Printing Durability (x $10^4$ sheets) | Developing Time (seconds) |
| Example 14 | (1) | (1) | P-1 | 2.8 | 25 |
| Example 15 | (2) | (1) | P-2 | 2.8 | 27 |

(continued)

| | Lithographic Printing Plate Precursor | Polymer Fine Particle | Polymer Compound (Star Polymer) | Evaluation Results | |
|---|---|---|---|---|---|
| | | | | Printing Durability (x $10^4$ sheets) | Developing Time (seconds) |
| Example 16 | (3) | (1) | P-3 | 2.8 | 25 |
| Example 17 | (4) | (1) | P-4 | 2.8 | 25 |
| Example 18 | (5) | (1) | P-5 | 2.8 | 20 |
| Example 19 | (6) | (1) | P-11 | 3.3 | 26 |
| Example 20 | (7) | (1) | P-12 | 3.3 | 28 |
| Example 21 | (8) | (1) | P-13 | 3.3 | 26 |
| Example 22 | (9) | (1) | P-14 | 3.3 | 26 |
| Example 23 | (10) | (1) | P-15 | 3.3 | 21 |
| Example 24 | (11) | (1) | P-32 | 2.6 | 23 |
| Example 25 | (12) | (1) | P-33 | 3.2 | 24 |
| Example 26 | (17) | (1) | P-11 | 4.0 | 30 |
| Comparative Example 5 | (13) | (1) | R-1 | 2.6 | 35 |
| Comparative Example 6 | (14) | None | P-11 | 2.6 | 33 |
| Comparative Example 7 | (15) | (1) | R-2 | 2.6 | 33 |
| Comparative Example 8 | (16) | (2) | P-11 | 2.6 | 33 |

INDUSTRIAL APPLICABILITY

According to the invention, a lithographic printing plate precursor which has good developing property while maintaining printing durability of a lithographic printing plate after development and a lithographic printing method can be provided.

DESCRIPTION OF REFERENCE NUMERALS AND SIGNS

- 4: Lithographic printing plate precursor (PS plate)
- 6: Developing unit
- 10: Drying unit
- 16: Carrying-in roller
- 20: Developing tank
- 22: Transport roller
- 24: Brush roller
- 26: Squeeze roller (carrying-out roller)
- 28: Backup roller
- 36: Guide roller
- 38: Skewer roller

## Claims

1. A lithographic printing plate precursor comprising, on a support having a hydrophilic surface, an image-recording layer containing a polymerizable compound, a polymerization initiator, a fine particle of polymer having a polyethyleneoxy group in a side chain and a polymer compound, wherein the polymer compound has a star-like shape in which a main chain is branched to three or more branches and the branched main chains have at least any of a polyethyleneoxy group and a polypropyleneoxy group in side chains thereof.

2. The lithographic printing plate precursor as claimed in Claim 1, wherein the polymer compound having a star-like shape in which a main chain is branched to three or more branches has an ethylenically unsaturated group in a side chain of the branched main chain.

3. The lithographic printing plate precursor as claimed in Claim 1 or 2, wherein the polymer compound having a star-like shape in which a main chain is branched to three or more branches has a polyethyleneoxy group in a side chain of the branched main chain.

4. The lithographic printing plate precursor as claimed in any one of Claims 1 to 3, wherein the polymer compound having a star-like shape in which a main chain is branched to three or more branches is obtained by radical polymerization of a monomer having at least any of a polyethyleneoxy group and a polypropyleneoxy group in the presence of a compound having three or more thiol groups.

5. The lithographic printing plate precursor as claimed in any one of Claims 1 to 4, wherein the image-recording layer contains an infrared absorbing agent.

6. The lithographic printing plate precursor as claimed in any one of Claims 1 to 5, wherein a protective layer is provided on the image-recording layer.

7. The lithographic printing plate precursor as claimed in any one of Claims 1 to 6, wherein the image-recording layer is capable of being removed with at least any of printing ink and dampening water.

8. A lithographic printing method comprising, after either mounting the lithographic printing plate precursor as claimed in Claim 7 on a printing machine and exposing imagewise the lithographic printing plate precursor with laser or exposing imagewise the lithographic printing plate precursor as claimed in Claim 7 with laser and mounting the exposed lithographic printing plate precursor on a printing machine, supplying at least any of printing ink and dampening water onto the exposed lithographic printing plate precursor to remove an unexposed area of the image-recording layer and performing printing.

## Patentansprüche

1. Lithografiedruckplattenvorläufer, umfassend, auf einem Träger mit einer hydrophilen Oberfläche, eine Bildaufzeichnungsschicht, die eine polymerisierbare Verbindung, einen Polymerisationsinitiator, einen Feinpartikel eines Polymers, das eine Polyethylenoxygruppe in einer Seitenkette aufweist, und eine Polymerverbindung umfasst, worin die Polymerverbindung eine sternähnliche Form aufweist, worin eine Hauptkette sich in drei oder mehr Verzweigungen verzweigt und die verzweigten Hauptketten mindestens eines von einer Polyethylenoxygruppe und einer Polypropylenoxygruppe in Seitenketten hiervon aufweisen.

2. Lithografiedruckplattenvorläufer gemäß Anspruch 1, worin die Polymerverbindung mit einer sternähnlichen Form, worin eine Hauptkette in drei oder mehr Verzweigungen verzweigt ist, eine ethylenisch ungesättigte Gruppe in einer Seitenkette der verzweigten Hauptkette aufweist.

3. Lithografiedruckplattenvorläufer gemäß Anspruch 1 oder 2, worin die Polymerverbindung mit einer sternähnlichen Form, worin eine Hauptkette in drei oder mehr Verzweigungen verzweigt ist, eine Polyethylenoxygruppe in einer Seitenkette der verzweigten Hauptkette aufweist.

4. Lithografiedruckplattenvorläufer gemäß irgendeinem der Ansprüche 1 bis 3, worin die Polymerverbindung mit einer sternähnlichen Form, worin eine Hauptkette in drei oder mehr Verzweigungen verzweigt ist, durch radikalische Polymerisation eines Monomers, das zumindest eines von einer Polyethylenoxygruppe und einer Polypropylenoxygruppe aufweist, in der Gegenwart einer Verbindung mit drei oder mehr Thiolgruppen erhalten ist.

5. Lithografiedruckplattenvorläufer gemäß irgendeinem der Ansprüche 1 bis 4, worin die Bildaufzeichnungsschicht einen Infrarotabsorber enthält.

6. Lithografiedruckplattenvorläufer gemäß irgendeinem der Ansprüche 1 bis 5, worin eine Schutzschicht auf der Bildaufzeichnungsschicht vorgesehen ist.

7. Lithografiedruckplattenvorläufer gemäß irgendeinem der Ansprüche 1 bis 6, worin die Bildaufzeichnungsschicht mit zumindest einem von Drucktinte und Anfeuchtwasser entfernt werden kann.

8. Lithografisches Druckverfahren, umfassend entweder nach dem Montieren des Lithografiedruckplattenvorläufers gemäß Anspruch 7 auf einer Druckmaschine und bildweisem Belichten des Lithografiedruckplattenvorläufers mit einem Laser, oder nach dem bildweisen Belichten des Lithografiedruckplattenvorläufers gemäß Anspruch 7 mit einem Laser und Montieren des belichteten Lithografiedruckplattenvorläufers auf einer Druckmaschine, das Zuführen von zumindest einem von Drucktinte und Anfeuchtwasser zu dem belichteten Lithografiedruckplattenvorläufer, um einen nichtbelichteten Bereich der Bildaufzeichnungsschicht zu entfernen, und Durchführen des Druckens.

## Revendications

1. Précurseur de plaque d'impression lithographique comprenant, sur un support ayant une surface hydrophile, une couche d'enregistrement d'image contenant un composé polymérisable, un initiateur de polymérisation, une particule fine de polymère ayant un groupe polyéthylèneoxy dans une chaîne latérale et un composé polymère, où le composé polymère a une forme en étoile dans laquelle une chaîne principale est ramifiée en trois ramifications ou plus et les chaînes principales ramifiées ont au moins l'un parmi un groupe polyéthylèneoxy et un groupe polypropylèneoxy dans des chaînes latérales de celles-ci.

2. Précurseur de plaque d'impression lithographique tel que revendiqué dans la revendication 1, dans lequel le composé polymère ayant une forme en étoile dans laquelle une chaîne principale est ramifiée en trois ramifications ou plus a un groupe à insaturation éthylénique dans une chaîne latérale de la chaîne principale ramifiée.

3. Précurseur de plaque d'impression lithographique tel que revendiqué dans la revendication 1 ou 2, dans lequel le composé polymère ayant une forme en étoile dans laquelle une chaîne principale est ramifiée en trois ramifications ou plus a un groupe polyéthylèneoxy dans une chaîne latérale de la chaîne principale ramifiée.

4. Précurseur de plaque d'impression lithographique tel que revendiqué dans l'une quelconque des revendications 1 à 3, dans lequel le composé polymère ayant une forme en étoile dans laquelle une chaîne principale est ramifiée en trois ramifications ou plus est obtenu par polymérisation radicalaire d'un monomère ayant au moins l'un parmi un groupe polyéthylèneoxy et un groupe polypropylèneoxy en présence d'un composé ayant trois groupes thiol ou plus.

5. Précurseur de plaque d'impression lithographique tel que revendiqué dans l'une quelconque des revendications 1 à 4, dans lequel la couche d'enregistrement d'image contient un agent absorbant les infrarouges.

6. Précurseur de plaque d'impression lithographique tel que revendiqué dans l'une quelconque des revendications 1 à 5, dans lequel une couche protectrice est prévue sur la couche d'enregistrement d'image.

7. Précurseur de plaque d'impression lithographique tel que revendiqué dans l'une quelconque des revendications 1 à 6, dans lequel la couche d'enregistrement d'image est capable d'être enlevée avec au moins l'une parmi une encre d'impression et une eau de mouillage.

8. Procédé d'impression lithographique comprenant, soit après le montage du précurseur de plaque d'impression lithographique tel que revendiqué dans la revendication 7 sur une machine d'impression et l'exposition sous forme d'image du précurseur de plaque d'impression lithographique avec un laser ou après l'exposition sous forme d'image du précurseur de plaque d'impression lithographique tel que revendiqué dans la revendication 7 avec un laser et le montage du précurseur de plaque d'impression lithographique exposé sur une machine d'impression, le fait de fournir au moins l'une parmi une encre d'impression et une eau de mouillage sur le précurseur de plaque d'impression

lithographique exposé pour enlever une zone non exposée de la couche d'enregistrement d'image et d'effectuer une impression.

FIG. 1

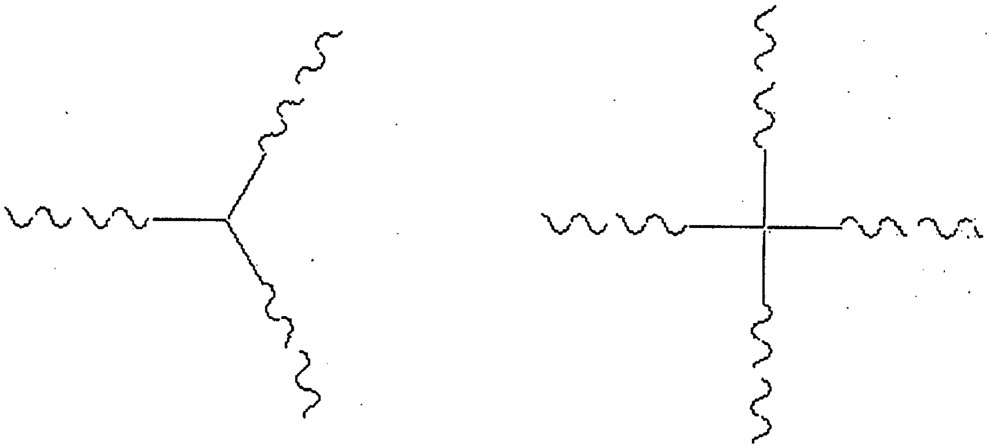

Three-branched

Four-branched

FIG. 2

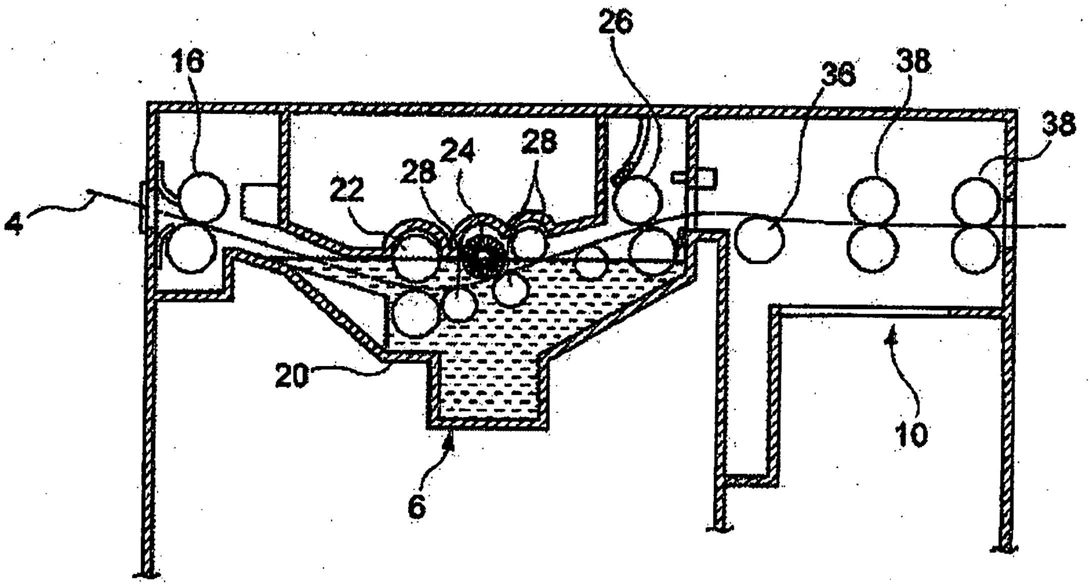

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- JP 2001277740 A
- JP 2001277742 A
- JP 2002287334 A
- US 20030064318 A
- JP 2007249036 A
- JP 3084227 B
- JP 6087908 A
- JP 7021633 B
- JP 2006508380 T
- JP 2002287344 A
- JP 2008256850 A
- JP 2001342222 A
- JP 9179296 A
- JP 9179297 A
- JP 9179298 A
- JP 2004294935 A
- JP 2006243493 A
- JP 2002275129 A
- JP 2003064130 A
- JP 2003280187 A
- JP 10333321 A
- JP 48041708 B
- JP 51037193 A
- JP 2032293 B
- JP 2016765 B
- JP 2003344997 A
- JP 2006065210 A
- JP 58049860 B
- JP 56017654 B
- JP 62039417 B
- JP 62039418 B
- JP 2000250211 A
- JP 2007094138 A
- US 7153632 B
- JP 8505958 T
- JP 2007293221 A
- JP 2007293223 A
- JP 2008195018 A
- JP 8108621 A
- JP 61166544 A
- JP 2002328465 A
- JP 5158230 A
- US 4069055 A
- JP 4365049 A
- US 4069056 A
- EP 104143 A
- US 20080311520 A
- JP 2150848 A
- EP 370693 A
- EP 233567 A
- EP 297443 A
- EP 297442 A
- US 4933377 A
- US 4760013 A
- US 4734444 A
- US 2833827 A
- DE 2904626
- DE 3604580
- DE 3604581
- JP 2001133969 A
- JP 2002278057 A
- JP 2006297907 A
- JP 2007050660 A
- JP 2008284858 A
- JP 2009090645 A
- JP 2009208458 A
- JP 2008284817 A
- JP 2006091479 A
- JP 10282679 A
- JP 2304441 A
- JP 2005238816 A
- JP 2005125749 A
- JP 2006239867 A
- JP 2006215263 A
- JP 2006188038 A
- JP 2001253181 A
- JP 2001322365 A
- US 2714066 A
- US 3181461 A
- US 3280734 A
- US 3902734 A
- US 3276868 A
- US 4153461 A
- US 4689272 A
- JP 5045885 A
- JP 6035174 A
- US 3458311 A
- JP 55049729 B
- JP 2005250216 A
- JP 2006259137 A
- JP 2005119273 A
- JP 2008203359 A
- JP 2008276166 A
- JP 2009047927 A
- JP 2007206217 A

**Non-patent literature cited in the description**


- **S. I. SCHLESINGER.** *Photogr. Sci. Eng.,* 1974, vol. 18, 387
- **T. S. BAL et al.** *Polymer,* 1980, vol. 21, 423
- **J. V. CRIVELLO et al.** *Macromolecules,* 1977, vol. 10 (6), 1307
- **J. V. CRIVELLO et al.** *J. Polymer Sci., Polymer Chem. Ed.,* vol. 17, 1047
- **C. S. WEN et al.** *Teh, Proc. Conf. Rad. Curing ASIA,* October 1988, 478
- Colour Index (C.I.). Pigment Technology Society of Japan, 1977
- **SAISHIN.** Ganryo Oyou Gijutsu. CMC Publishing Co., Ltd, 1986
- Insatsu Ink Gijutsu. CMC Publishing Co., Ltd, 1984